# EUROPEAN PATENT APPLICATION

(11) **EP 2 043 154 A2**
(43) Date of publication of application: **01.04.2009**
(21) Application number: 08017007.9
(22) Date of filing: 26.09.2008
(51) Int. Cl.: H01L 27/142, H01L 31/042, H01L 31/048

(54) **Thin-film solar battery module and method of producing the same**

(30) Priority: 28.09.2007 JP 2007254928
(71) Applicant: Sharp Kabushiki Kaisha, Osaka-shi, Osaka 545-8522 (JP)
(72) Inventor: Takeda, Toru, Katsuragi-shi Nara 639-2162 (JP); Nasuno, Yoshiyuki, Kashihara-shi Nara 634-0006 (JP); Toyokawa, Masahiro, Kashiba-shi Nara 639-0256 (JP); Fukuoka, Yusuke, Ikoma-gun Nara 636-0111 (JP)
(74) Representative: Müller - Hoffmann & Partner

(57) **Abstract**

A thin-film solar battery module comprising: a plurality of thin-film solar batteries; a supporting plate; and a frame, the thin-film solar battery having a string in which a plurality of thin-film photoelectric conversion elements, each formed by sequentially stacking a first electrode layer, a photoelectric conversion layer and a second electrode layer on a surface of an insulated substrate, are electrically connected in series, wherein the frame is attached to an outer circumference of the supporting plate in a condition that the plurality of thin-film solar batteries are arranged and fixed on the supporting plate.

## Description

### BACKGROUND OF THE INVENTION

### Field of the invention

The present invention relates to a thin-film solar battery module and a method of producing the same, and more specifically, to a thin-film solar battery module made up of a plurality of thin-film solar batteries and a method of producing the same.

### Description of the Related Art

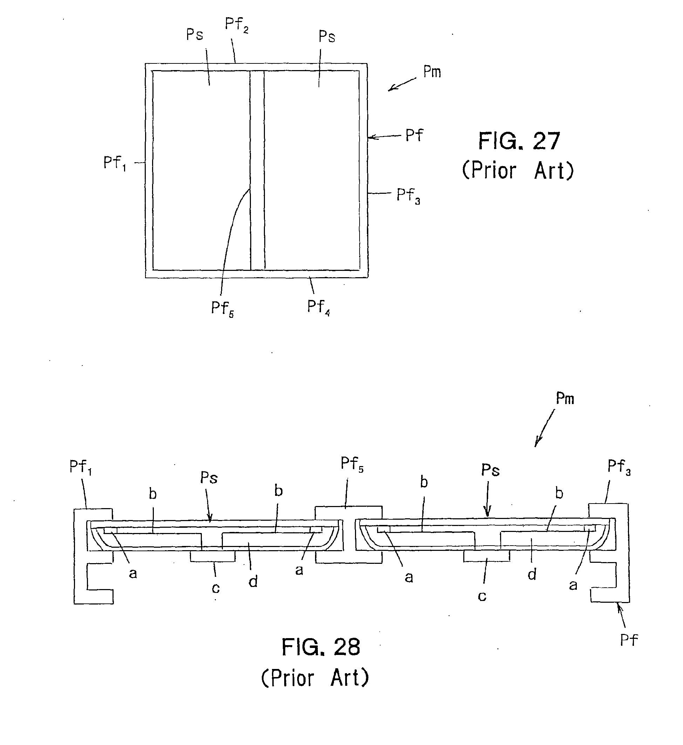

As shown in Fig. 27 and Fig. 28, a conventional thin-film solar battery module Pm includes a thin-film solar battery Ps having a string in which a plurality of thin-film photoelectric conversion elements each formed by sequentially stacking a first electrode layer, a photoelectric conversion layer (semiconductor layer) and a second electrode layer on an insulated substrate, are electrically connected in series, and a frame Pf attached to an outer circumference of the two thin-film solar batteries Ps, to connect and reinforce the solar batteries. As the frame Pf, those made of aluminum are widely used.

To be more specific, in the thin-film solar battery Ps, the first electrode layer and the second electrode layer on both end sides in a serial connecting direction of the string are connected to external terminals in a terminal box (c) via a bus bar (a) and a retrieving line (b), while a back face side and an end face side thereof are sealed by a sealing member (d). And by attaching frame members Pf₁ to Pf₅ to the outer circumference of the two thin-film solar batteries Ps and between the solar batteries, a sheet of thin-film solar battery module Pm is fabricated (for example, Kaneka Corporation Product pamphlet "Kaneka Silicon PV" issued on January 1, 2006).

In such a conventional thin-film solar battery module Pm, use of the frame member Pf₅ between the two thin-film solar batteries Ps will lead increase in frame number, increase in module weight, increased troublesome of a frame attaching work, increased complexity of handling of wiring, and a problem that a production cost of the thin-film solar battery module rises.

The present invention provides a thin-film solar battery module capable of solving such a problem and reducing the production cost.

### SUMMARY OF THE INVENTION

According to the present invention, there is provided a thin-film solar battery module including: a plurality of thin-film solar batteries; a supporting plate; and a frame, the thin-film solar battery having a string in which a plurality of thin-film photoelectric conversion elements, each formed by sequentially stacking a first electrode layer, a photoelectric conversion layer and a second electrode layer on a surface of an insulated substrate, are electrically connected in series, wherein the frame is attached to an outer circumference of the supporting plate in a condition that the plurality of thin-film solar batteries are arranged and fixed on the supporting plate.

According to another aspect of the present invention, there is provided a method of producing a thin-film solar battery module including: a sealing and fixing step that arranges a plurality of thin-film solar batteries on a supporting plate and sealing and fixing them by an insulating sealing material, each of the thin-film solar batteries having a string made up of a plurality of thin-film photoelectric conversion elements electrically connected in series, the thin-film photoelectric conversion element being formed by sequentially stacking a first electrode layer, a photoelectric conversion layer and a second electrode layer on an insulating substrate; and a frame attaching step that attaches a frame to the outer circumference of the supporting plate that supports the plurality of thin-film solar batteries.

According to the present invention, by arranging and fixing a plurality of thin-film solar batteries on one supporting plate and attaching a frame on the outer circumference of the supporting plate, it is possible to obtain a thin-film solar battery module in which a frame between solar batteries is omitted while keeping a strength thereof. Therefore, it is possible to reduce the members of frame, reduce the module weight, reduce the step number of frame attachment, simplify the handling of wiring. As a result, it is possible to reduce the production cost of the thin-film solar battery module. Further, absence of a frame between solar batteries provides an advantage that an appearance of the thin-film solar battery module improves is obtained.

### BRIEF DESCRIPTION OF THE DRAWINGS

Figs. 1A to 1C are views showing Embodiment 1-1 of a thin-film solar battery module of the present invention, in which Fig. 1A is a plan view, Fig. 1B is a front view, and Fig. 1C is a right lateral elevation;
Fig. 2 is a bottom view showing the thin-film solar battery module according to Embodiment 1-1;
Fig. 3 is a front section view showing the thin-film solar battery module according to Embodiment 1-1;
Fig. 4 is an exploded view showing the thin-film solar battery module according to Embodiment 1-1 in an exploded state;
Fig. 5 is a perspective view showing a thin-film solar battery;
Figs. 6A and 6B are section views in which Fig. 6A is a section view along the line B-B in Fig. 5, and Fig. 6B is a section view along the line A-A in Fig. 5;
Fig. 7 is a section view showing two thin-film solar batteries according to Embodiment 1-1 arranged to neighbor;
Fig. 8 is a perspective view showing a state that two thin-film solar batteries according to Embodiment 1-1 are arranged to neighbor, to which a wiring sheet is connected;
Fig. 9 is a configuration view of a wiring sheet in Embodiment 1-1;
Figs. 10A to 10B are section views showing a frame attachment site of the thin-film solar battery module according to Embodiment 1-1, in which Fig. 10A corresponds to a cross section of Fig. 6A, and Fig. 10B corresponds to a cross section of Fig. 6B;
Fig. 11 is a perspective view showing a state that a string is formed in a solar battery fabrication step in Embodiment 1-1;
Fig. 12 is a cross section view along the line A-A in Fig. 11;
Fig. 13 is a plan view showing a thin-film solar battery module according to Embodiment 1-2;
Fig. 14 is a plan view showing a thin-film solar battery module according to Embodiment 1-3;
Fig. 15 is a view showing a state that a thin-film solar battery in Embodiment 1-3 is arranged;
Fig. 16 is a partial sectional plan view showing a thin-film solar battery module according to Embodiment 2-1;
Fig. 17 is a perspective view showing a thin-film solar battery in Embodiment 2-1;
Figs. 18A and 18B are section views in which the thin-film solar batteries in Embodiment 2-1 are arranged laterally, in which Fig. 18A shows parallel connection state, and Fig. 18B shows serial connection state;
Fig. 19 is a view for explaining the step of forming a non-conductive end face region of the thin-film solar battery in Embodiment 2-1;
Fig. 20 is a partial sectional plan view showing a thin-film solar battery module according to Embodiment 2-2;
Fig. 21 is a perspective view showing a thin-film solar battery in Embodiment 2-2;
Fig. 22 is a view for explaining the step of forming a non-conductive end face region of the thin-film solar batteries in Embodiment 2-2;
Fig. 23 is a partial sectional plan view showing a thin-film solar battery module according to Embodiment 2-3;
Fig. 24 is a plan view showing a thin-film solar battery module according to Embodiment 2-4;
Fig. 25 is a plan view showing a thin-film solar battery module according to Embodiment 3;
Fig. 26 is a perspective view of a thin-film solar battery in Embodiment 3;
Fig. 27 is a plan view of a conventional thin-film solar battery module; and
Fig. 28 is a front section view of a conventional thin-film solar battery module.

### DETAILED DESCRIPTION OF THE INVENTION

The thin-film solar battery module of the present invention includes a plurality of thin-film solar batteries, a supporting plate, and a frame, and the thin-film solar battery has a string in which a plurality of thin-film photoelectric conversion elements, each formed by sequentially stacking a first electrode layer, a photoelectric conversion layer and a second electrode layer on a surface of an insulated substrate, are electrically connected in series, and the frame is attached to an outer circumference of the supporting plate in a condition that the plurality of thin-film solar batteries are arranged and fixed on the supporting plate.

Hereinafter in this specification, "thin-film solar battery" is also referred simply as "solar battery".

In the present invention, the supporting plate is not particularly limited insofar as it has enough strength to support a plurality of thin-film solar batteries without bowing, and for example, an insulating plate made of glass, plastic or ceramic, or a conducting plate made of aluminum or stainless steel, or a composite material plate formed by coating a conductive plate with resin may be used.

When a conductive plate or a composite material plate is used, particularly, if the frame is made of conductive material, it is desired to increase an insulation resistance between the frame and the supporting plate, between the frame and the thin-film solar battery and between the supporting plate and the thin-film solar batterieso as to obtain a dielectric withstand voltage necessary for the thin-film solar battery module.

Here, the term "dielectric withstand voltage" means a property that no discharge occurs between a frame and a thin-film solar battery even when a specific high voltage is applied between the frame and the thin-film solar battery, and whether a predetermined dielectric withstand voltage is obtained may be examined by a dielectric withstand voltage test defined by the international standard (IEC: 61646). In a case of a thin-film solar battery module having system voltage of lower than 1000 V, the international standard requires a dielectric withstand voltage against a lightning surge withstand voltage of 6 KV.

Therefore, as the supporting plate, an insulating plate with which a high dielectric withstand voltage can be readily obtained is preferred, and particularly, a supporting plate formed of a reinforced glass or a reinforced plastic is more preferred, and a reinforced glass having excellent weather resistance is particularly preferred. The reinforced glass may be a tempered glass or a laminated glass. Whether the supporting plate has a translucency is not particularly limited, however, when the supporting plate side is used as a light receiving surface of the thin-film solar battery, the supporting plate should have the translucency, and the reinforced glass is more preferred than the tempered plastic also in the point of translucency.

In the present invention, the frame has a function of improving the strength as the thin-film solar battery module, and may further has a function as a attaching member and a supporting member in attaching the thin-film solar battery module to a site of installation.

The material for the frame is not particularly limited, and for example, generally known metals such as aluminum and stainless steel, or ABS, polycarbonate, polymethacrylate and the like plastics having relatively excellent mechanical strength and weather resistance, or composite materials in which the metal is coated with the resin can be recited.

In the thin-film solar battery module of the present invention, as for the plurality of thin-film solar batteries, it is preferred that at least an entire string is sealed by a sealing member and thus is protected from water. As the sealing member, a sealing resin sheet (for example, ethylene-vinyl acetate copolymer (EVA)) may be used, and each thin-film solar battery may be made water resistant by covering the string with a sealing resin sheet and crimping in a heating and a vacuum. A protective sheet may be overlaid on the sealing resin sheet.

Further, between the frame and the supporting plate, and between the frame and the thin-film solar battery, an insulating cushion material may be provided. This cushion material prevents backlash of the supporting plate with respect to the frame, while improving the dielectric withstand voltage as described above.

As the above photoelectric conversion layer in the thin-film solar battery, a pn junction type, a pin junction type, a hetero junction type, and a tandem structure type in which plural layers of pn or pin junction are laminated can be recited. In the present specification, the later-described first conductive type means p type or n type, and the second conductive type means n type or p type which is the opposite conductive type from that of the first conductive type.

In the present invention, the insulated substrate of the thin-film solar battery may have a function as an attaching plate for attaching the thin-film solar battery to the supporting plate, as well as a function as the substrate of the thin-film solar battery. In this case, an insulated substrate may be placed on the supporting plate, and fixed, for example, by adhesion or screwing, and adhesion without using a metal member is preferred from the view point of the dielectric withstand voltage as described above. In such adhesion, a sealing resin sheet as described above may be used.

Further, the thin-film solar battery module of the present invention may be applied to both of a super-straight type thin-film solar battery using a translucent substrate as the insulated substrate, and a sub-straight type thin-film solar battery using a non-translucent substrate.

In a case of a super-straight type in which an insulated substrate is fixed on the supporting plate, since the first electrode layer side is a light incident side, translucent plates are used as the supporting plate, the sealing resin sheet and the insulated substrate. In a case of a sub-straight type in which an insulated substrate is fixed on a supporting plate, since the second electrode layer side is the light incident side, presence/absence of translucency of the supporting plate, the sealing resin sheet and the insulated substrate is not limited. However, the thin-film solar battery of the super-straight type in which the first electrode layer side is the light incident side is preferred because a wiring work is conveniently conducted from the second electrode layer side, and a light reception on the second electrode layer side will be interfered by the wiring in the sub-straight type.

Further, in the thin-film solar battery module of the present invention, the second electrode layer side of the thin-film solar battery may be placed and fixed on the supporting plate. In this case, the thin-film solar battery can be adhered on the supporting plate by placing the thin-film solar battery on the supporting plate via the sealing resin sheet with the second electrode layer side down, and heating and pressuring the thin-film solar battery in a vacuum. This advantageously enables sealing of the string and fixing of the supporting plate at the same time.

In a case of the cell attachment structure of the solar battery in which the second electrode layer faces the supporting plate, when the thin-film solar battery is a super-straight type, a side opposite to the supporting plate is the light incident side, and when the thin-film solar battery is a sub-straight type, the supporting plate side is the light incident side. However, also in this case, the thin-film solar battery of the super-straight type in which the first electrode layer side is the light receiving face is preferred because the wiring work is conveniently conducted from the second electrode layer side, and the light reception on the second electrode layer side will be interfered by the wiring in the sub-straight type.

The thin-film solar battery module of the present invention may have following configurations.
(1) In the plurality of thin-film solar batteries, neighboring two thin-film solar batteries are arranged apart from each other.
(2) A protective member between the neighboring two thin-film solar batteries in the plurality of thin-film solar batteries, that protects opposing end edges of the respective thin-film solar batteries is further provided.
   The purpose of configuring the thin-film solar battery module as in the above (1) and (2) is to prevent occurrence of cracking of the insulated substrate by collision between opposing end edges of the insulated substrates of the two neighboring thin-film solar batteries, due to slight bending of the supporting plate, or by erroneous collision between the thin-film solar batteries in arranging them on the supporting plate.
   When the thin-film solar battery is configured to little cause cracking of substrate, for example, when a resin substrate of polyimide or the like which little causes cracking of substrate is used as the insulated substrate of the thin-film solar battery, opposing end edges of the neighboring two thin-film solar batteries may be arranged in contact with each other.
   In the configurations (1) and (2), when a metal frame (for example, generally used aluminum frame) as the frame which is made of a conductive material is used, following configurations are preferred for improving the dielectric withstand voltage of the thin-film solar battery module.
(3) In the thin-film solar battery, a surface of the insulated substrate within a predetermined insulation distance from the metal frame is a non-conductive surface region, and the string is situated on the inside of an end face which is close to the metal frame in the insulated substrate, and a part situated within the predetermined insulation distance in an end face opposing to the other of the neighboring thin-film solar batteries is a non-conductive end face region.
(4) When at least one electrode layer of the first electrode layer and the second electrode layer in string formation adheres on an outer circumferential end face of the insulated substrate of the thin-film solar battery, a surface of the insulated substrate within a predetermined insulation distance from the metal frame is a non-conductive surface region where the first electrode layer, the photoelectric conversion layer and the second electrode layer do not adhere, and in the plurality of thin-film solar batteries, an end part situated at least within the predetermined insulation distance from the metal frame in opposing end face of the neighboring two thin-film solar batteries is a non-conductive end face region where the first electrode layer and the second electrode layer do not adhere.
(5) In the thin-film solar battery, a surface of the insulated substrate within a predetermined insulation distance from the metal frame is a first non-conductive surface region, and a surface of the insulated substrate which is close to the other of the neighboring thin-film solar batteries is a second non-conductive surface region, and the string is situated on the inside of an end face of the insulated substrate, the second non-conductive surface region has the same width as that of the first non-conductive surface region.
   Here, in the present invention, in the non-conductive surface region and the non-conductive end face region described above, the first electrode layer, the photoelectric conversion layer and the second electrode layer are not necessarily completely removed, and they may partly remain insofar as their conductivity and dielectric withstand voltage will not lead any problem.
   Further, in the thin-film solar battery modules having the configurations (1) to (5), the neighboring two solar batteries may be connected in series or in parallel while they are arranged in a following manner.
(6) In the thin-film solar battery, the second electrode layer at one end in a serial connecting direction of the string is an extraction electrode for the first electrode layer of the neighboring thin-film photoelectric conversion element, and the photoelectric conversion layer has a first conductive type semiconductor layer on a side of the first electrode layer and a second conductive type semiconductor layer on a side of the second electrode layer, and in the two neighboring thin-film solar batteries arranged in the serial connecting direction of the string, strings of the two thin-film solar batteries are connected in series by being arranging the thin-film solar batteries in such orientation that the second electrode layer of one of the thin-film solar batteries and the extraction electrode of the other of the thin-film solar batteries are close to each other, and electrically connected between the second electrode layer and the extraction electrode of the thin-film solar batteries.
(7) In the thin-film solar battery, the second electrode layer at one end in a serial connecting direction of the string is an extraction electrode for the first electrode layer of the neighboring thin-film photoelectric conversion element, and the photoelectric conversion layer has a first conductive type semiconductor layer on a side of the first electrode layer and a second conductive type semiconductor layer on a side of the second electrode layer, in the two neighboring thin-film solar batteries arranged in the serial connecting direction of the string, strings of the two thin-film solar batteries are connected in parallel by arranging the thin-film solar batteries in such an orientation that the respective extraction electrodes are apart from each other or in such an orientation that the extraction electrodes are close to each other, and electrically connecting between the neighboring second electrode layers or between the neighboring extraction electrodes of the respective thin-film solar batteries.

In a following, Embodiments of the thin-film solar battery modules and methods of producing the same of the aforementioned configurations will be concretely explained with reference to drawings.

### (Embodiment 1-1)

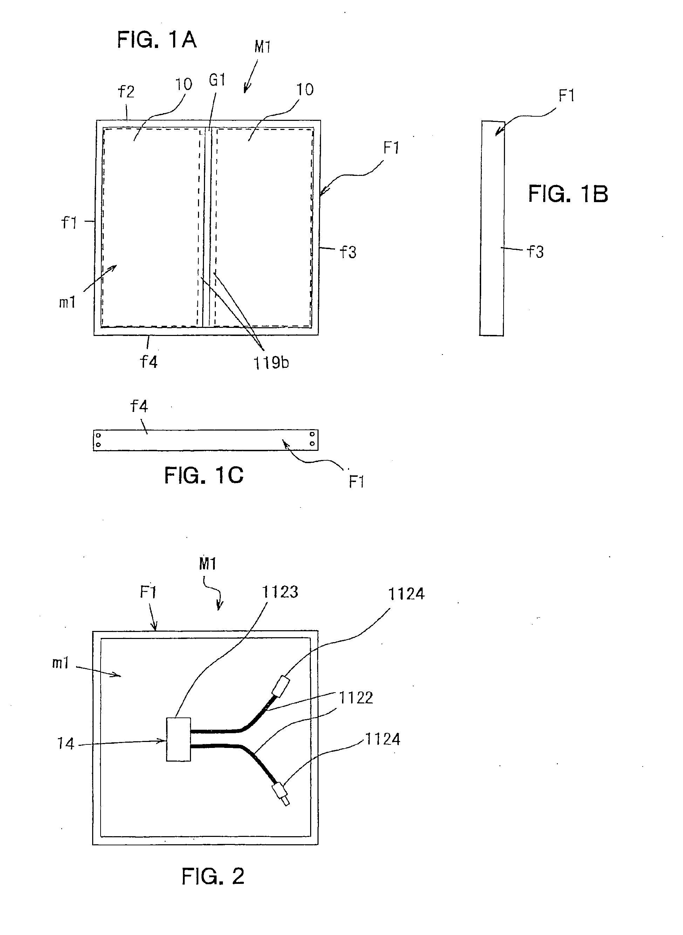

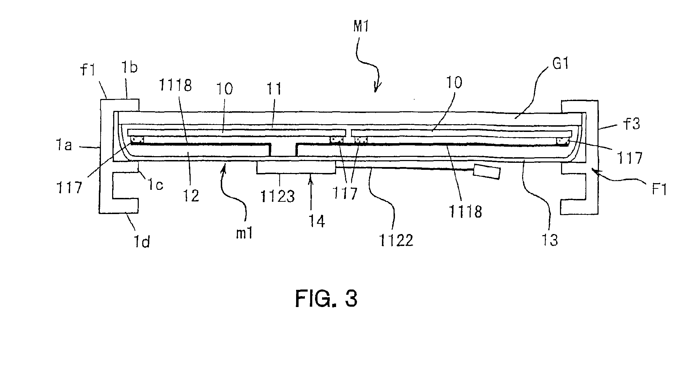

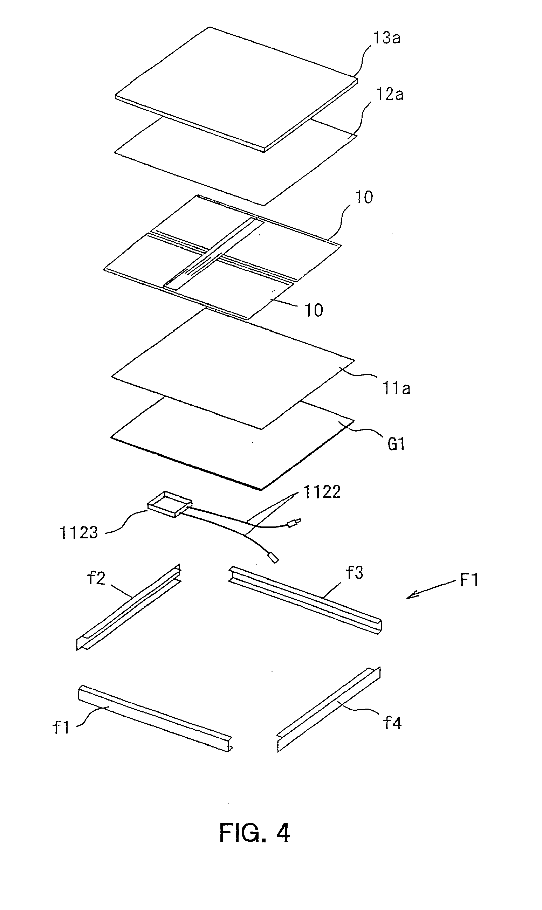

Figs. 1A to 1C are views showing Embodiment 1-1 of a thin-film solar battery module according to the present invention, in which Fig. 1A is a plan view, Fig. 1B is a front view, and Fig. 1C is a right side elevation. Fig. 2 is a bottom view showing the thin-film solar battery module of Embodiment 1-1. Fig. 3 is a front section view showing the thin-film solar battery module of Embodiment 1-1. Fig. 4 is an exploded view showing the thin-film solar battery module of Embodiment 1-1 in an exploded state.

### <Explanation of structure of thin-film solar battery module>

A thin-film solar battery module M 1 according to Embodiment 1-1 includes a reinforced glass G1 which is a supporting plate, two sheets of thin-film solar batteries 10 arranged apart from each other and fixed on the reinforced glass G1, and a frame F1 attached to an outer circumference of the reinforced glass G 1 serving as the supporting plate that supports the two sheets of thin-film solar batteries 10.

The thin-film solar battery module M 1 further includes an adhesion layer 11 that adhesively fix the two sheets of thin-film solar batteries 10 on the reinforced glass G1, a covering layer 12 that covers the whole of the two sheets of thin-film solar batteries 10 fixed on the reinforced glass G1, a protective layer 13 that covers the covering layer 12, and a wiring connection part 14 that electrically connects the two sheets of thin-film solar batteries 10.

In a following, a structure formed by fixing the two sheets of thin-film solar batteries 10 on the reinforced glass G1 by the adhesion layer 11, and covering them with the covering layer 12 and the protective layer 13, to which the wiring connection part 14 is attached, is called a module body m1.

The reinforced glass G 1 is made of reinforced glass having thickness of about 2 to 4 mm, and is formed into a square plate shape.

The frame F 1 has four aluminum frame members f1 to f4 attached to four sides of the square module body m1, and a screw member (not illustrated) for joining neighboring frame members.

The frame member f1 includes a plate part 1a having approximately the same length as that of one side of the module body m1, and three protruding piece parts protruding perpendicularly from an inner face of the plate part 1a and extend over an entire length of the plate part 1a. Two of the protruding piece parts of the frame member f1 are sandwiching pieces 1b, 1c for sandwiching one end edge of the module body m 1 while fitted therebetween, and a remaining protruding piece part is an attaching piece 1d for attaching to an installation site. Further, in both ends of the inner face of the plate part 1a between the sandwiching pieces 1b, 1c, a cylindrical screw attaching portion having a screw hole is integrally provided. The frame member f3 placed to be opposite to the frame member f1 has the same configuration as the frame member f1.

The frame member f2 has a plate part and a pair of sandwiching pieces which are similar to those of the frame member f1, however a length of the sandwiching pieces is designed to be shorter than the plate part, and a L-shaped part including the attaching piece in the frame member f1 is omitted. Further, in both ends of the plate part, screw insertion holes are formed at positions coinciding with positions where the screw attaching portions are formed in the frame member f1, f3. The frame member f4 placed to be opposite to the frame member f2 has the same configuration as the frame member f2.

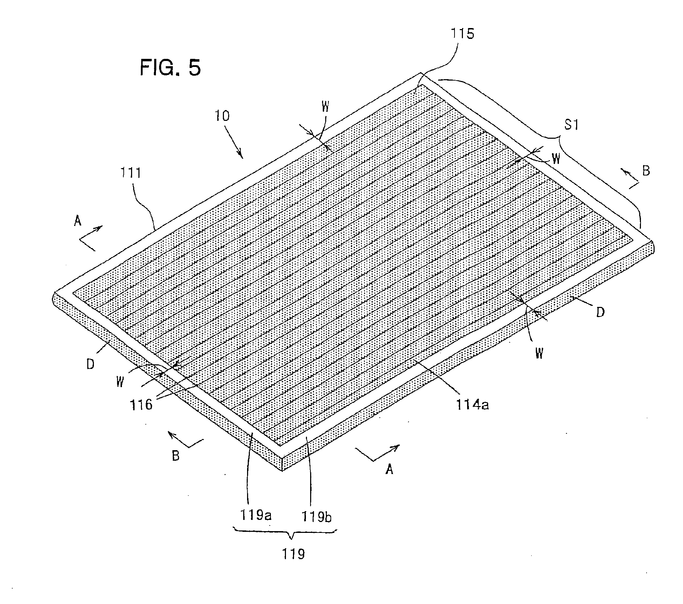

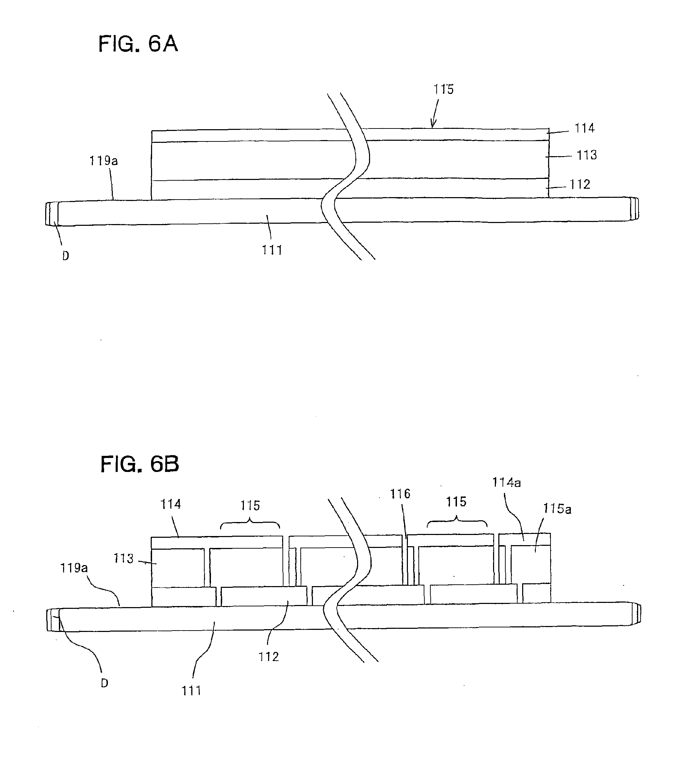

Fig. 5 is a perspective view of the thin-film solar battery 10, Fig. 6A is a section view along the line B-B in Fig. 5, and Fig. 6B is a section view along the line A-A in Fig. 5.

The thin-film solar battery 10 is a super straight type thin-film solar battery including a rectangular transparent insulated substrate 111, and a string S 1 on a surface of the transparent insulated substrate 111, made up of a plurality of thin-film photoelectric conversion elements 115 electrically connected in series, each formed by sequentially stacking a first electrode layer 112, a photoelectric conversion layer 113 and a second electrode layer 114.

As the transparent insulated substrate 111, for example, a glass substrate, and a polyimide or the like resin substrate, having heat resistance in the subsequent film forming process and translucency can be used. The first electrode layer 112 is formed of a transparent conductive film, and preferably formed of a transparent conductive film made of a material containing ZnO or SnO₂. The material containing SnO₂ may be SnO₂ itself, or a mixture of SnO₂ and other oxide (for example, ITO which is mixture of SnO₂ and In₂O₃).

A material of each semiconductor layer forming the photoelectric conversion layer 113 is not particularly limited, and may be composed of, for example, a silicon-based semiconductor, a CIS (CuInSe2) compound semiconductor, or a CIGS (Cu(In, Ga)Se₂) compound semiconductor. In a following, explanation will be made while taking a case where each semiconductor layer is made of the silicon-based semiconductor as an example. The term "silicon-based semiconductor" means amorphous or microcrystalline silicon, or semiconductors formed by adding carbon or germanium or other impurity to amorphous or microcrystalline silicon (silicon carbide, silicon germanium and so on). The term "microcrystalline silicon" means silicon of mixed phase state of crystalline silicone having small crystal particle size (about several tens to thousand angstroms), and amorphous silicon. The microcrystalline silicon is formed, for example, when a crystalline silicon thin film is formed at low temperature using a non-equilibrated process such as a plasma CVD method.

The photoelectric conversion layer 113 is formed by stacking a p-type semiconductor layer, an i-type semiconductor layer and an n-type semiconductor layer in this order from a side of the first electrode layer 112.

The p-type semiconductor layer is doped with p-type impurity atoms such as boron or aluminum, and the n-type semiconductor layer is doped with n-type impurity atoms such as phosphorus. The i-type semiconductor layer may be a completely non-doped semiconductor layer, or may be a weak p-type or weak n-type semiconductor layer containing a small amount of impurity and having a sufficient photoelectric converting function. The terms "amorphous layer" and "microcrystalline layer" used herein respectively mean semiconductor layers of amorphous substances and micro crystals.

Configuration and material of the second electrode layer 114 are not particularly limited, however, as one example, the second electrode layer 114 has a laminate structure in which a transparent conductive film and a metal film are stacked on a photoelectric conversion layer. The transparent conductive film is made of, for example, SnO₂, ITO or ZnO. The metal film is made of silver, aluminum and the like metal. The transparent conductive film and the metal film may be formed by CVD, sputtering, vapor deposition and the like method.

The string S 1 is formed in its surface with a plurality of separation grooves 116. These plurality of separation grooves 116 are formed to extend in a direction orthogonal to the serial connecting direction (long side direction of the transparent insulated substrate 111) for electrically separating the second electrode layers 114 and the photoelectric conversion layers 113 of the neighboring two thin-film photoelectric conversion elements 115. The laminate film 115a made up of the first electrode layer, the photoelectric conversion layer and the second electrode layer at one end in the serial connecting direction of the string S 1 (right end in Fig. 6B) does not substantially contribute to power generation because it is formed to have small width in the serial connecting direction, and hence the second electrode layer of the laminate film 115a is used as an extraction electrode 114a of the first electrode layer 112 of the neighboring thin-film photoelectric conversion layer 115.

The string S 1 of the solar battery 10 is formed on an inner side than three end faces that are close to the frame F1 and one end face that is opposite to the neighboring other solar battery 10 in the transparent insulated substrate 111 (see Fig.1A). That is, the outer circumferential region on the surface of the transparent insulated substrate 111 is a non-conductive surface region 119 having a certain width W where the first electrode layer 112, the photoelectric conversion layer 113 and the second electrode layer 114 do not adhere. In the non-conductive surface region 119, a part close to the frame F1 is a first non-conductive surface region 119a, and a part close to the neighboring other solar battery 10 is a second non-conductive surface region 119b. Details of the non-conductive surface region 119 will be described later.

In the solar battery 10, on an entire face of an outer circumferential end face of the transparent insulated substrate 111, a deposition film D made up of the first electrode layer 112, the photoelectric conversion layer 113 and the second electrode layer 114 adheres. The deposition film D adheres to the outer circumferential end face of the transparent insulated substrate 111 when the string S 1 is formed on the surface of the transparent insulated substrate 111, and has a thickness of about 2 to 5 µm.

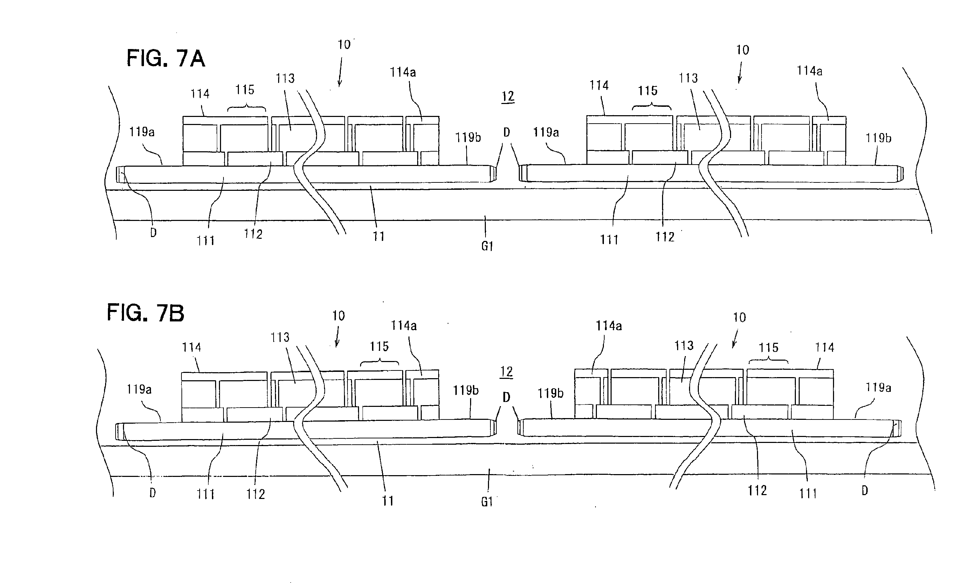

As shown in Fig. 7A or 7B, the two sheets of thin-film solar batteries 10 thus formed are arranged laterally in the serial connecting direction of the string S 1 so that they neighbor but are apart from each other.

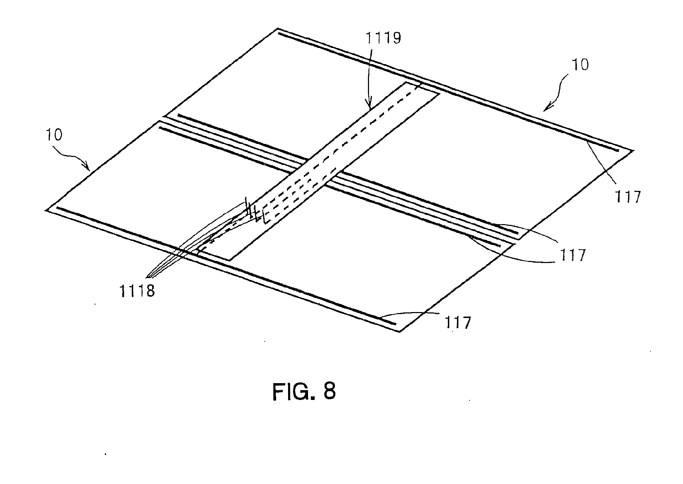

Fig. 7A shows a state that two solar batteries 10 are arranged so that the extraction electrode 114a of one solar battery 10 is close to the second electrode layer 114 of the other solar battery 10, while Fig. 7B shows a state that two solar batteries 10 are arranged so that the extraction electrode 114a of one solar battery 10 is close to the extraction electrode 114a of the other solar battery 10. Although omitted in Fig. 7, on the second electrode layer 114 and the extraction electrode 114a in both ends of the serial connecting direction of the strings S1 in each solar battery 10, a bus bar 117 (see Fig. 8) is electrically connected via a solder material along a longitudinal direction thereof.

These solar batteries 10 are arranged apart from each other so that a distance between end faces opposing to each other in outer circumferential end faces of the respective insulated substrates 111 is about 0.1 to 5 mm, and between the opposing end faces, the covering layer 12 enters. This prevents the insulated substrates 111 from coming into contact with each other to cause cracking of substrate. In Fig. 7, a boundary between the covering layer 12 in a circumference of each solar battery 10, and the adhesion layer 11 on the reinforced glass G1 is not illustrated. This is because, both the covering layer 12 and the adhesion layer 11 on the reinforced glass G1 are formed of resin sheets, and these are integrated by heat fusion. The details will be described later.

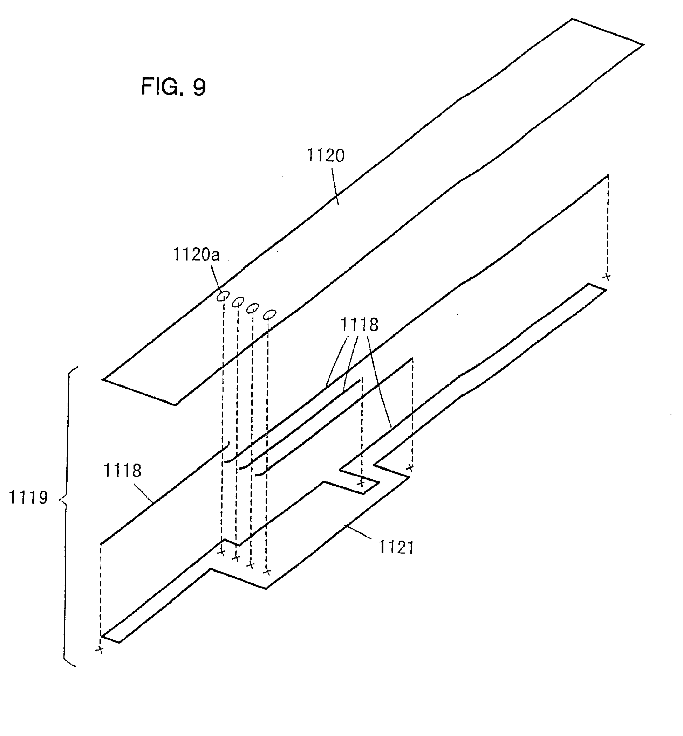

Fig. 8 shows a state that retrieving lines 1118 (for example, copper wire) are electrically connected to each of the bus bars 117 of the two solar batteries 10, and Fig. 9 is a configuration explanatory view of a wiring sheet 1119 having the retrieving lines 1118.

The wiring sheet 1119 has four retrieving lines 1118 having a predetermined length, a first insulation sheet 1120 and a second insulation sheet 1121 that sandwich these retrieving lines 1118 in a condition that they are substantially parallel and apart from each other, and placed in the serial connecting direction on the two laterally arranged solar batteries 10.

The first insulation sheet 1120 has a plurality of retrieving holes 1120a for retrieving one ends of the respective retrieving lines 1118 outside, and the second insulation sheet 1121 is formed so that only the other ends of the respective retrieving lines 1118 are exposed outside. These first and second insulation sheets 1120, 1121 are formed of resin sheets (for example, polyethylene, polypropylene, and PET), and are bonded to each other by heat fusion while the four retrieving lines 1118 are arranged and sandwiched therebetween.

The plurality of retrieving holes 1120a of the wiring sheet 1119 are provided in positions which are close to each other, and one ends of the retrieving lines 1118 are retrieved outside through the respective retrieving holes 1120a in a bent condition. The covering layer 12 and the protective layer 13 are also provided with retrieving holes for retrieving a bent one end of each retrieving line 1118 outside.

The plurality of retrieving lines 1118 have such a length that is placed in a position where the other ends thereof can contact the respective bus bars 117 of the laterally arranged two solar batteries 10.

To be more specific, in the present Embodiment 1-1, among four retrieving lines 1118, neighboring two retrieving lines 1118 are connected with two bus bars 117 in distant positions, and remaining two neighboring retrieving lines 1118 are connected with two bus bars 117 in close positions.

The aforementioned wiring connection part 14 has the wiring sheet 1119, and a terminal box 1123 having two output lines 1122 which are electrically connected with one ends exposed outside of the respective retrieving lines 1118 in the wiring sheet 1119.

One ends of the two output lines 1122 are provided with retrieving terminals, and to each of the retrieving terminals, two retrieving lines 1118 are electrically connected, while the other ends of the two output lines 1122 are provided, respectively with a connector 1124.

The terminal box 1123 is fixed on a surface of the protective layer 13, for example, by an adhesive of silicone rein type, and is kept from water entering inside.

The two sheets of thin-film solar batteries 10 are connected in series or in parallel as will be described later.

In a case of serial connection, the neighboring two solar batteries 10 arranged in the serial connecting direction of the string S 1 are electrically connected while they are oriented so that the second electrode layer 114 of one solar battery 10 and the extraction electrode 114a of the other solar battery 10 are close to each other, whereby, the strings S 1 of the two solar batteries 10 are connected in series.

Concretely, as shown in Fig. 7A, in arranging the two solar batteries 10 and forming wiring with the use of the wiring sheet 1119, the extraction electrode 114a and the second electrode layer 114 which are close to each other in the two solar batteries 10 are connected by connecting the two retrieving lines 1118, and the second electrode layer 114 and the extraction electrode 114a which are apart from each other are connected to the two output lines 1122 via other two retrieving lines 1118, whereby the two sheets of thin-film solar batteries 10 are connected in series.

In a case of parallel connection, in the neighboring two solar batteries 10 arranged in the serial connecting direction of the string S1, the solar batteries 10 are arranged in such an orientation that the respective extraction electrodes 214a are apart from each other or in such an orientation that the respective extraction electrodes 214a are close to each other, and the neighboring second electrode layers 214 or the neighboring extraction electrodes 214a in the respective solar batteries 10 are electrically connected, whereby the strings S 1 of the two thin-film solar batteries are connected parallel with each other.

Concretely, as shown in Fig. 7B, in arranging two solar batteries 10, and forming wiring with the use of the wiring sheet 1119, extraction electrodes 114a which are close to each other in the two solar batteries 10 are connected to one output line 1122 via the two retrieving lines 1118, and the second electrode layers 114 which are apart from each other are connected to the other output line 1122 via the two retrieving lines 1118, whereby parallel connection of the two sheets of thin-film solar batteries 10 is achieved. In the parallel connection, each solar battery 10 may be arranged in a direction opposite to that shown in Fig. 7B.

By appropriately handling the respective retrieving lines 1118 connected to the respective bus bars 117 of the two solar batteries 10, the solar batteries 10 arranged as shown in Fig. 7A can be connected in parallel or the solar batteries 10 arranged as shown in Fig. 7B can be connected in series.

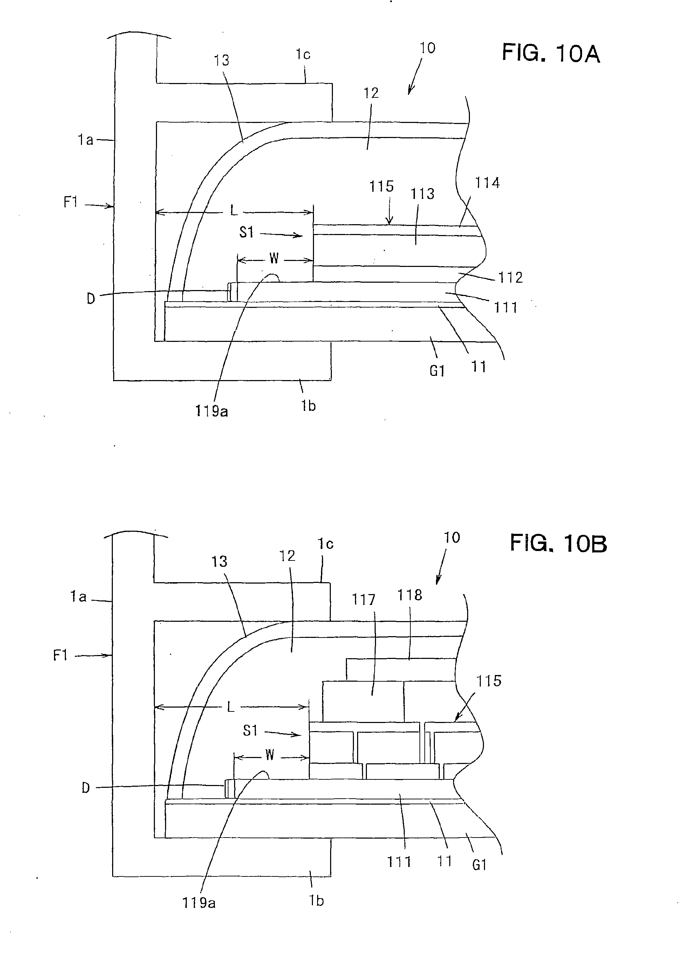

Figs. 10A and 10B are section views showing a frame attachment site of the thin-film solar battery module M1, and Fig. 10A corresponds to a cross section of Fig. 6A and Fig. 10B corresponds to a cross section of Fig. 6B.

As shown in Figs. 10A and 10B, in a condition that an outer circumference of the module body m1 is pressed between the pair of sandwiching pieces 1b, 1c of the frame F1, a distance L from the plate part 1 a of the frame F 1 to the string S 1 of the solar battery 10 is the aforementioned predetermined insulation distance. When the string S 1 itself or at least one of the first electrode layer 112 and the second electrode layer 114 is formed on the surface of the transparent insulated substrate 111 within this predetermined insulation distance L, a predetermined dielectric withstand voltage is not obtained between the frame F1 and the string S1. In other words, when a voltage of as high as 6 KV, for example, is applied between the frame F1 and the second electrode layer 114 or the extraction electrode 114a in an end part in a serial connecting direction of the string S1, discharge occurs between the frame F 1 and the string S1.

In the present invention, in order to achieve a predetermined dielectric withstand voltage for preventing such discharge, the first non-conductive surface region 119a having the width W where the first electrode layer 112, the photoelectric conversion layer 113 and the second electrode layer 114 do not adhere is formed on the surface of the transparent insulated substrate 111 within the predetermined insulation distance L. For example, when the predetermined insulation distance L is set at 9 to 20 mm, the width W of the first non-conductive surface region 119a is 8.4 to 20 mm, preferably 8.4 to 14 mm, and more preferably 8.4 to 11 mm, in order to achieve dielectric withstand voltage against 6 KV which is lightning surge withstand voltage according to international standard.

Further, on surfaces which are close to each other in the neighboring solar batteries 10, the second non-conductive surface region 119b having the same width W are formed (see Fig. 1A). In this case, although the surfaces which are close to each other in the neighboring solar batteries 10 are distant from the plate part 1a of the frame F1 by the predetermined insulation distance L or larger, the second non-conductive surface regions 119b having the width W are required. In other words, the deposition film D made up of the first electrode layer 112 and the second electrode layer 114 adheres in an entire end face of an outer circumference of the transparent insulated substrate 111. Since a shortest distance from the adhered film D to the frame F1 is smaller than the predetermined insulation distance L, conduction or discharge occurs between the frame F1 and the string S 1 via the deposition film D if there is no second non-conductive surface region 119b. For this reason, the second non-conductive surface regions 119b are provided while taking the deposition film D into account.

### <Explanation of production of thin-film solar battery module>

The aforementioned thin-film solar battery module M 1 may be produced by a method of producing a thin-film solar battery module which includes a solar battery fabrication step that fabricates the plurality of thin-film solar batteries; a sealing and fixing step that seals and fixes the plurality of thin-film solar batteries arranged on a supporting plate by an insulating sealing material; and a frame attaching step that attaches a frame to an outer circumference of the supporting plate that supports the plurality of thin-film solar batteries.

In a following, these steps will be explained sequentially.

### [Solar battery fabrication step]

A solar battery fabrication step includes a string forming step that forms a string, which is formed by electrically connecting a plurality of thin-film photoelectric conversion elements in series, the thin-film photoelectric conversion element having a first electrode layer, a photoelectric conversion layer and a second electrode layer stacked sequentially on at least a surface of an insulated substrate; and a film removing step that removes the first electrode layer, the photoelectric conversion layer and the second electrode layer on a surface of the insulated substrate positioned within a predetermined insulation distance from the frame which will be attached to the supporting plate in the subsequent frame attaching step and forming a first non-conductive surface region, when the frame is made of a conductive material.

Further, in the film removing step, when an electrode layer of at least one of the first electrode layer and the second electrode layer adheres on an outer circumferential end face of the insulated substrate during the string forming step, the first electrode layer, the photoelectric conversion layer and the second electrode layer on surfaces which are close to each other in the two thin-film solar batteries which neighbor when a plurality of thin-film solar batteries are arranged in the subsequent sealing and fixing step are removed, and a second non-conductive surface region having the same width as the width of the first non-conductive surface region is formed.

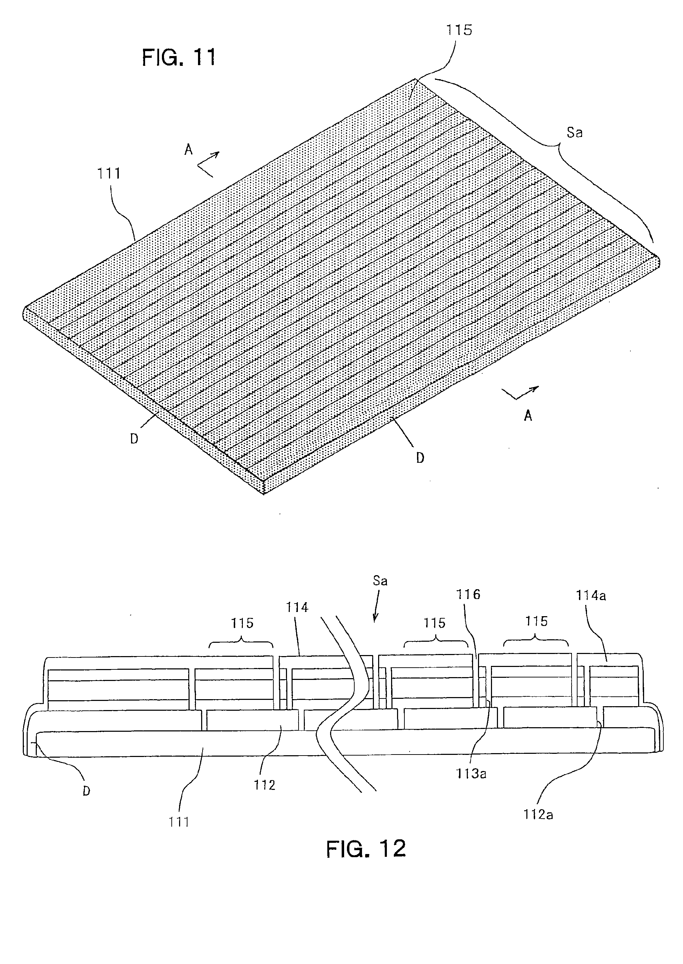

In the string forming step, string Sa as shown in Fig. 11 and Fig. 12 is formed in a following manner.

First, the first electrode layer 112 is stacked on the transparent insulated substrate 111 so that the film thickness is about 500 to 1000 nm by a heat CVD method, sputtering method or the like. The transparent insulated substrate 111 is about 400 to 2000 mm x 400 to 2000 mm in size, and about 0.7 to 5.0 mm in thickness.

Next, the first electrode layer 112 is partly removed at a predetermined interval (about 7 to 18 mm) by a laser scribing method, to form a plurality of first separation grooves 112a.

Subsequently, the photoelectric conversion layer 113 having a film thickness of about 300 to 3000 nm is overlaid so that it covers the first electrode layer 112 separated by the first separation grooves 112a, for example, by a plasma CVD method. As the photoelectric conversion layer 113, for example, a silicon-based semiconductor thin film is recited, and the p-type semiconductor layer, the i-type semiconductor layer and the n-type semiconductor layer are sequentially stacked on the first electrode layer 112.

Thereafter, a part of the photoelectric conversion layer 113 is removed at a predetermined interval (about 7 to 18 mm) by a laser scribing method, to form a plurality of the contact lines 113a.

Subsequently, a transparent conductive layer and a metal layer are stacked in this order so that they cover the photoelectric conversion layer 113, for example, by the sputtering method or a vapor deposition method, to form the second electrode layer 114. As a result, the contact lines 113a are filled with the second electrode layer 114. A thickness of the transparent conductive layer is about 300 to 2000 nm, and a thickness of the metal layer is about 100 to 10000 nm.

Next, by the laser scribing method, the photoelectric conversion layer 113 and the second electrode layer 114 are partly removed at a predetermined interval (about 7 to 18 mm) to form a plurality of second separation grooves 116.

In the laser scribing method for forming the first separation grooves 112a, the contact lines 113a and the second separation grooves 116, a YAG laser or a YVO₄ laser having a wavelength adjusted to be absorbed in the layer to be removed in forming each groove can be used.

For example, the first electrode layer 112 may be patterned using a fundamental wave of YAG laser beam (wavelength: 1064 nm) or a fundamental wave of YVO₄ laser beam absorbed in the transparent conductive film, to form the first separation grooves 112a.

Further, the semiconductor layer 113 may be patterned, for example, by a second high harmonic wave of Nd:YAG laser (wavelength 532nm) to form the contact lines 113a. At this time, since the second high harmonic wave of Nd:YAG laser is little absorbed in the first electrode layer 112 (transparent conductive film), the first electrode layer 112 is not removed.

The semiconductor layer 113 and the second electrode layer 114 may be removed with this second high harmonic wave of Nd:YAG laser (wavelength 532nm) to form the second separation grooves 116 also.

In this manner, the string Sa wherein the plurality of strip-like thin-film photoelectric conversion elements 115 are connected in series on the entire surface of the transparent insulated substrate 111 is formed. In the string forming step, as shown in Fig. 11 and Fig. 12, on the outer circumferential end face of the transparent insulated substrate 111, the deposition film D made up of the first electrode layer 112 and the second electrode layer 114 adheres. This is because in a film forming apparatus, films are formed while the outer circumferential end face of the transparent insulated substrate 111 is not covered. By placing the transparent insulated substrate 111 on a tray dedicated for substrate, and covering the outer circumferential end face of the transparent insulated substrate 111 with the tray, the deposition film D will not adhere on the outer circumferential end face, however, the production cost rises because many trays are required, and the step of setting the transparent insulated substrate 111 on the tray is added, and maintenance for removing the film adhered to the tray surface is required. Therefore, in the present Embodiment 1-1, a film forming step not using a tray is employed.

### [Film removing step]

In a film removing step, the first electrode layer 112, the photoelectric conversion layer 113 and the second electrode layer 114 in the outer circumferential region on the surface of the transparent insulated substrate 111 are removed by light beam, to form the non-conductive surface region 119 having the width W ranging from 8.4 to 11 mm.

As a result, the thin-film solar battery 10 having the non-conductive surface region 119 in an outer circumference on the surface of the transparent insulated substrate 111, and having the aforementioned string S1 formed inside thereof is formed. Although the film may be removed by a mechanical method such as polishing or particle spraying, the method of removing by light beam is desired because it is the cleanest and the most practical method.

As the light beam, a fundamental wave of YAG laser beam (wavelength: 1064nm) or a fundamental wave of YVO₄ laser beam is preferably used. Since the fundamental wave of YAG laser beam and the fundamental wave of YVO₄ laser beam respectively penetrate through the transparent insulated substrate 111, and tend to be absorbed by the transparent first electrode layer 112 such as SnO₂, it is possible to selectively heat the first electrode layer 112 by irradiating with these light beams from a side of the transparent insulated substrate 111, and to make the first electrode layer 112, the photoelectric conversion layer 113 and the second electrode layer 114 evaporate by that heat.

Here, in the present invention, the term YAG laser means Nd:YAG laser, and the Nd:YAG laser is formed of crystals of yttrium aluminum garnet (Y₃Al₅O₁₂) containing neodymium ion (Nd³⁺). The YAG laser oscillates a fundamental wave of YAG laser beam (wavelength: 1064 nm).

The term YVO₄ laser means Nd:YVO₄ laser, and Nd:YVO₄ laser is formed of YVO₄ crystals containing neodymium ion (Nd³⁺). The YVO₄ laser oscillates a fundamental wave of YVO₄ laser beam (wavelength: 1064 nm).

Thereafter, on surfaces of the second electrode layer 114 and the extraction electrode 114a in the serial connecting direction of the strings S1, the bus bars 117 are electrically connected via a solder material (see Fig. 8).

### [Sealing and fixing step]

In the sealing and fixing step, on the reinforced glass G1, an EVA sheet for adhesion layer 11 having roughly the same size as the reinforced glass G1, and having a thickness of about 0.2 to 1.0 mm is placed. A size of the reinforced glass G1 is about 400 to 2000 mm x 400 to 2000 mm, and a thickness of the reinforced glass G 1 is about 0.7 to 5.0 mm.

Then on the EVA sheet for adhesion layer 11 a, two sheets of thin-film solar batteries 10 are arranged laterally while they are apart from each other by about 0.1 to 3.0 mm, and then the retrieving lines 1118 of the wiring sheet 1119 are electrically connected to the respective bus bars 117 with a solder material (see Fig. 4 and Fig. 8).

Subsequently, an EVA sheet for covering layer 12a is placed on the two solar batteries 10, and a sheet for protective layer 13a formed of a triple-layered laminate film of PET /Al/PET is placed thereon. The EVA sheet for covering layer 12a and the sheet for protective layer 13a are formed in advance with retrieving holes for allowing end parts of the respective retrieving lines 1118 in the wiring sheet 1119 protruding outside to pass.

And then by crimping these by heating in a vacuum, the two solar batteries 10 are fixed on the reinforced glass G 1 by the adhesive layer 11, and resin sealed by the covering layer 12 and the protective layer 13. As a result, the covering layer 12 enters between the two solar batteries 10, and the covering layer 12 and the adhesion layer 11 in an outer circumference of each solar battery 10 are bonded by heat fusion.

Thereafter, each output line 1122 in the terminal box 1123 is connected to each retrieving line 1118, and the terminal box 1123 is adhered on the surface of the protective layer 13, to complete the module body m1.

### [Frame attaching step]

In the frame attaching step, four frame members f1 to f4 are fit into the outer circumference of the module body m1, and neighboring frame members are fixed by a screw (see Figs. 1 to 4).

As a result, the thin-film solar battery module M 1 is complete.

According to the thin-film solar battery module M1 produced in this manner, it is possible to omit the frame between solar batteries while keeping the strength, and to reduce the members of the frame, lighten the module weight, reduce the step number of frame attachment, and simplify handling of wiring. As a result, it is possible to reduce the production cost.

Further, since there is no frame between the c solar batteries, a thin-film solar battery module with improved beauty appearance can be obtained.

The two solar batteries 10 may be arranged closely to each other in both a state shown in Fig. 7A and a state shown in Fig. 7B by using the same kind of solar batteries 10.

Further, since the transparent insulated substrates 111 of the neighboring solar batteries 10 do not contact with each other, the transparent insulated substrates 111 will not erroneously collide with each other to lead cracking in the substrates when a plurality of the solar batteries 10 are placed on the reinforced glass G1. Further, if the transparent insulated substrates 111 are in contact with each other, the transparent insulated substrates 111 may mutually receive pressure and lead cracking of the substrates when the reinforced glass G 1 bends even slightly at the time of transportation of the module body m1 or at the time of attaching the frame F1 to the module body m1, however, the thin-film solar battery module M 1 of the present Embodiment 1-1 will not cause such a problem.

### (Modified example of Embodiment 1-1)

In the film removing step illustrated in Fig. 5 and Fig. 6, in the first non-conductive surface region 119a near the both ends in a longitudinal direction of the separation groove 116, it is desired that the first electrode layer 112, the photoelectric conversion layer 113 and the second electrode layer 114 are removed stepwise rather than removed at once, and a film is formed in following steps.

In other words, first, the string S 1 near both ends in the longitudinal direction of the separation groove 116 is irradiated with the second high harmonic wave of YAG laser beam or the second high harmonic wave of YVO₄ laser beam as a first laser beam from the side of the transparent insulated substrate 111, and scanned in a direction orthogonal to the longitudinal direction of the separation groove 116, whereby the photoelectric conversion layer 113 and the second electrode layer 114 are evaporated to make grooves.

Thereafter, a further outer region of the groove is irradiated with a fundamental wave of YAG laser beam or a fundamental wave of the YVO₄ laser beam as a second laser beam having different wavelength from the first laser beam from the side of the transparent insulated substrate 111, and scanned in the direction orthogonal to the longitudinal direction of the separation groove 116, whereby the first electrode layer 112, the photoelectric conversion layer 113 and the second electrode layer 114 situated in the region further outside the groove are removed.

In this manner, the first non-conductive surface region 119a near the both ends in the longitudinal direction of the separation groove 116 can be formed by two-stage light beam irradiation. In this case, the first electrode layer 112 protrudes in the longitudinal direction of the separation groove 116 from the photoelectric conversion layer 113 and the second electrode layer 114. The protruding first electrode layer 112 corresponds to a bottom of the groove, and the groove disappears as a result of formation of the non-conductive surface region 119a.

In the light beam irradiation of the first stage, it is possible to remove only the photoelectric conversion layer 113 and the second electrode layer 114 without removing the first electrode layer 112 in a irradiation region of the second high harmonic wave of YAG laser beam or the second high harmonic wave of YVO₄ laser beam. As a result, longitudinal cross sections of the photoelectric conversion layer 113 and the second electrode layer 114 are exposed in the groove.

In the light beam irradiation of the second stage, there is at least a distance of width of the groove (light beam irradiation region in the first stage) between the exposed longitudinal cross sections of the photoelectric conversion layer 113 and the second electrode layer 114, and the evaporating first electrode layer 112. Therefore, in the light beam irradiation of the second stage, the evaporating first electrode layer 112 is less likely to adhere again to the longitudinal cross section of the photoelectric conversion layer 113 by the width of the groove, compared to a case where the first electrode layer 112, the photoelectric conversion layer 113 and the second electrode layer 114 in the circumferential part are evaporated at once. Therefore, it is possible to reduce the leak current between the first electrode layer 112 and the second electrode layer 114.

### (Embodiment 1-2)

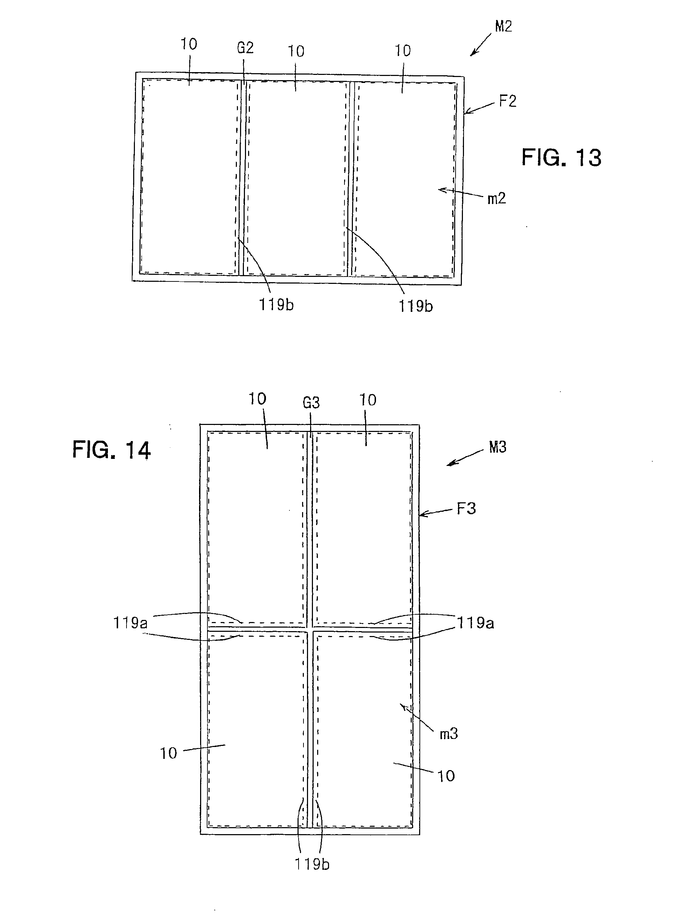

Fig. 13 is a plan view showing a thin-film solar battery module according to Embodiment 1-2.

A thin-film solar battery module M2 according to Embodiment 1-2 has generally the same configuration as the thin-film solar battery module M1 of Embodiment 1-1 as described above except that a module body m2 is fabricated by arranging three sheets solar batteries 10 of Embodiment 1-1 laterally (a serial connecting direction of thin-film photoelectric conversion element) on a rectangular reinforced glass G2, and a frame F2 corresponding to a length of each side of an outer circumference of the reinforced glass G2 is attached to the reinforced glass G2 and the module body m2. In Fig. 13, a similar configuration as that in Embodiment 1-1 is denoted by the same reference numeral.

The thin-film solar battery module M2 according to Embodiment 1-2 may be produced according to the production method of Embodiment 1-1, although the reinforced glass G2, frame F2, EVA sheet and the like used herein are larger in size.

Also in a case of Embodiment 1-2, solar batteries 10 are arranged apart from each other, and may be connected in series or connected in parallel using a wiring sheet having six retrieving lines (see Fig. 8). At this time, appropriate handling of the retrieving lines connected to the respective bus bars makes both serial connection and parallel connection possible regardless whether the three solar batteries 10 are arranged in the same orientation (see Fig. 7A), or one of the three solar batteries 10 is arranged in different orientation.

### (Embodiment 1-3)

Fig. 14 is a plan view showing a thin-film solar battery module according to Embodiment 1-3. A thin-film solar battery module M3 according to Embodiment 1-3 has generally the same configuration as the thin-film solar battery module M1 of Embodiment 1-1 as described above except that a module body m3 is fabricated by arranging four solar batteries 10 laterally and longitudinally on a rectangular reinforced glass G3, and a frame F3 corresponding to a length of each side of an outer circumference of the reinforced glass G3 is attached to the reinforced glass G3 and the module body m3. In Fig. 14, a similar configuration as that in Embodiment 1-1 is denoted by the same reference numeral.

The thin-film solar battery module M3 according to Embodiment 1-3 may be produced according to the production method of Embodiment 1-1, although the reinforced glass G3, frame F3, EVA sheet and the like used herein are larger in size. Also in this case, the solar batteries 10 are arranged apart from each other.

In this case, each two solar batteries 10 in the laterally arranged rows may be connected in series or in parallel in a similar manner as in Embodiment 1-1. Also by appropriately handling eight retrieving lines connected to each bus bar of four solar batteries 10, serial connection or parallel connection of four cells can be achieved.

### (Embodiment 1-4)

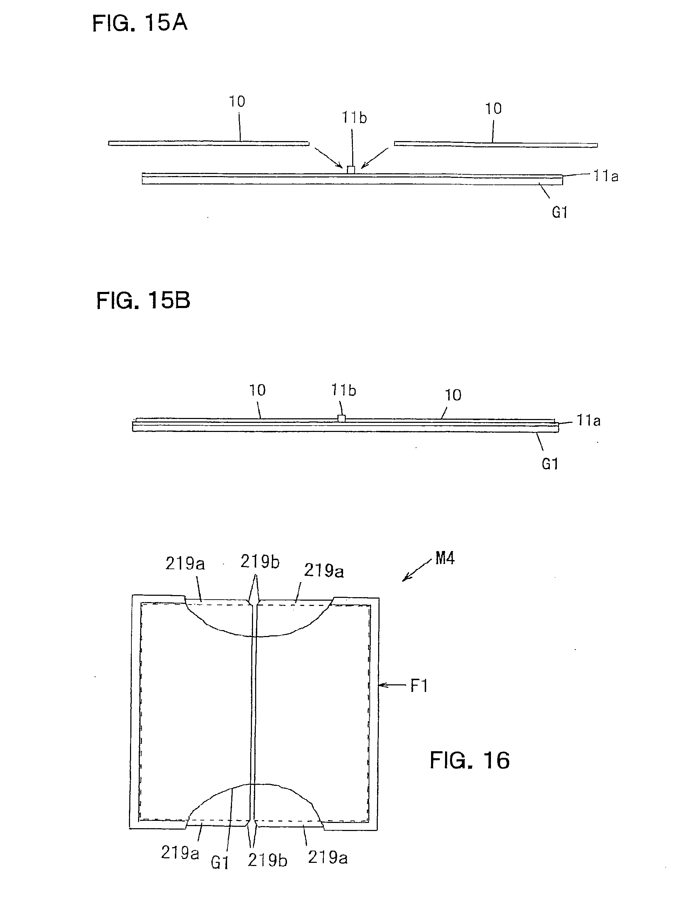

Fig. 15 is a process chart for explaining a part of production process of a thin-film solar battery module according to Embodiment 1-4.

In the aforementioned Embodiment 1-1 to Embodiment 1-3, in the sealing and fixing step, a plurality of solar batteries are arranged apart from each other on the EVA sheet for adhesion on the reinforced glass G, and then the entity of the plurality of solar batteries is crimped under heating by an EVA sheet for covering, so that the covering layer enters between the solar batteries to protect end edges of the solar batteries. In Embodiment 1-4, the end edges of solar batteries between the solar batteries are protected by a method different from such a method.

Explanation will be made for a case where two solar batteries 10 are used. As shown in Fig. 15A, in the sealing and fixing step, after placing the EVA sheet for adhesion 11a on the reinforced glass G1, a bar-like protective member 11b is disposed in a predetermined middle position of the EVA sheet 11a. Then two solar batteries 10 are placed on the EVA sheet 11a so that their end faces abut on the protective member 11b. Fig. 15B shows a state that the two solar batteries 10 are placed on the EVA sheet 11a. Following steps are as same as those in Embodiment 1-1. In Fig. 15, a similar element as that in Embodiment 1-1 is denoted by the same reference numeral.

The protective member 11b should be made of an insulation material of a softer material quality than the insulated substrate of the solar battery 10, and is preferably a resin material that is able to bond the adhesion layer and the covering layer by heat fusion, and EVA which is the same material of that of the adhesion layer and the covering layer is further preferred. Appropriate length of the protective member 11b is as same as a length of an end face of the contacting solar battery 10, however, it may be shorter than that. Alternatively, a plurality of shorter protective members 11b may be arranged at a predetermined interval. A thickness of the protective member 11b may be set at a distant dimension between the neighboring solar batteries 10 (for example, about 0.1 to 5.0 mm).

This enables rapid installation of the plurality of solar batteries 10 in positions where they are installed in the EVA sheet 11a, and prevents cracking of the substrates due to contact between the solar batteries.

### (Embodiment 2-1)

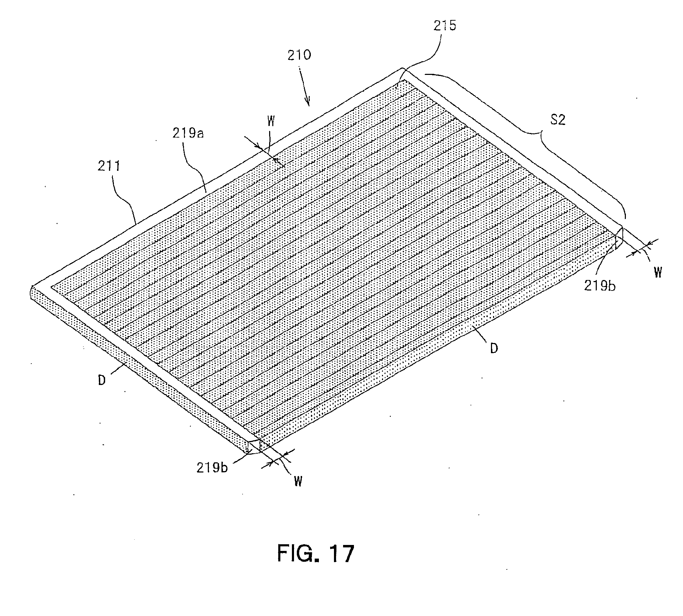

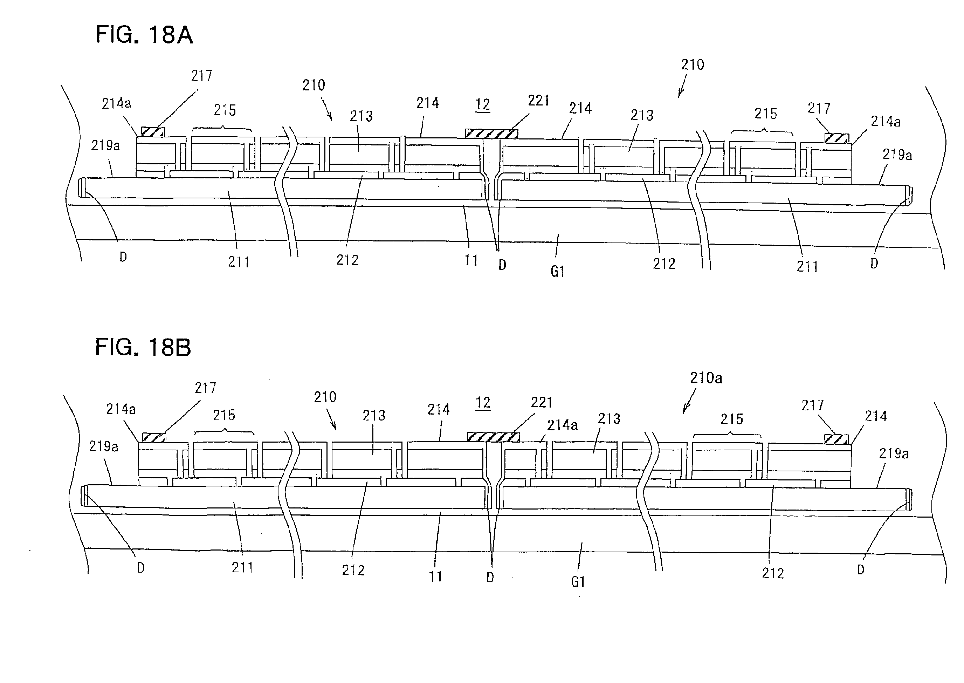

Fig. 16 is a partial section plan view showing a thin-film solar battery module M4 according to Embodiment 2-1, Fig. 17 is a perspective view showing a thin-film solar battery 210 in Embodiment 2-1, Fig. 18A and Fig.18B are section views in which thin-film solar batteries 210 are laterally arranged in Embodiment 2-1, Fig. 18A shows parallel connection state, and Fig. 18B shows serial connection state. In Fig. 16 to Fig. 18, a similar element as that in Embodiment 1-1 is denoted by the same reference numeral.

In the thin-film solar battery module M4 according to Embodiment 2-1, the thin-film solar battery 210 has increased effective power generation area that contributes to power generation, compared with the thin-film solar battery 10 of Embodiment 1-1 (see Fig. 5). The thin-film solar battery module M4 of Embodiment 2-1 has a substantially similar configuration to that of Embodiment 1-1 except for the difference of the solar battery 210.

The thin-film solar battery 210 of Embodiment 2-1 has a string S2 in which a plurality of thin-film photoelectric conversion elements 215 each formed by sequentially stacking a first electrode layer 212, a photoelectric conversion layer 213 and a second electrode layer 214 on a transparent insulated substrate 211, are electrically connected in series, and the string S2 is formed an inner side than three end faces which are close to the frame F1 in the insulated substrate 211. That is, a surface of the transparent insulated substrate 211 positioned within at least a predetermined insulation distance from the frame F1 is a non-conductive surface region 219a where the first electrode layer 212, the photoelectric conversion layer 213 and the second electrode layer 214 do not adhere.

Further, in the plurality of thin-film solar batteries, a part positioned within at least the predetermined insulation distance from the frame F1 in opposing end faces of the neighboring two thin-film solar batteries 210 is a non-conductive end face region 219b where the first electrode layer 212 and the second electrode layer 214 do not adhere. The second electrode layer on one end side in the serial connecting direction of the string S2 is formed into an extraction electrode 214a of the first electrode layer 212 of the neighboring thin-film photoelectric element 215 as is a case with Embodiment 1-1.

In other words, in the thin-film solar battery 10 of Embodiment 1-1 (see Fig. 5), parts which are close to each other on surfaces of the neighboring two solar batteries 210 are the second non-conductive surface regions 119b, while in the thin-film solar battery 210 of Embodiment 2-1, since the string S2 is formed up to parts which are close to each other on surfaces of the neighboring two solar batteries 210, the effective power generation area is increased.

In this case, since on an outer circumferential end face of the transparent insulated substrate 211 in the solar battery 210, a deposition film D similar to that in Embodiment 1-1 adheres, the deposition films D adhering to the end faces of the neighboring two thin-film solar batteries 210 are in contact with the strings S2 of this end face side. When the deposition film D of this end face is present within the predetermined insulation distance L from the frame F (see Fig. 10), discharge will occur via the deposition film D between the frame F1 and the string S2 when such high voltage as 6KV for testing a predetermined dielectric withstand voltage is applied.

In order to make the cell 210 have the predetermined dielectric withstand voltage, on opposing end faces of the neighboring two thin-film solar batteries 210, the non-conductive end face region 219b is formed by cutting off a corner part of the transparent insulated substrate 211 in each cell 210 in an end part located at least within predetermined insulation distance L from the frame Flwhich will be attached to the supporting plate.

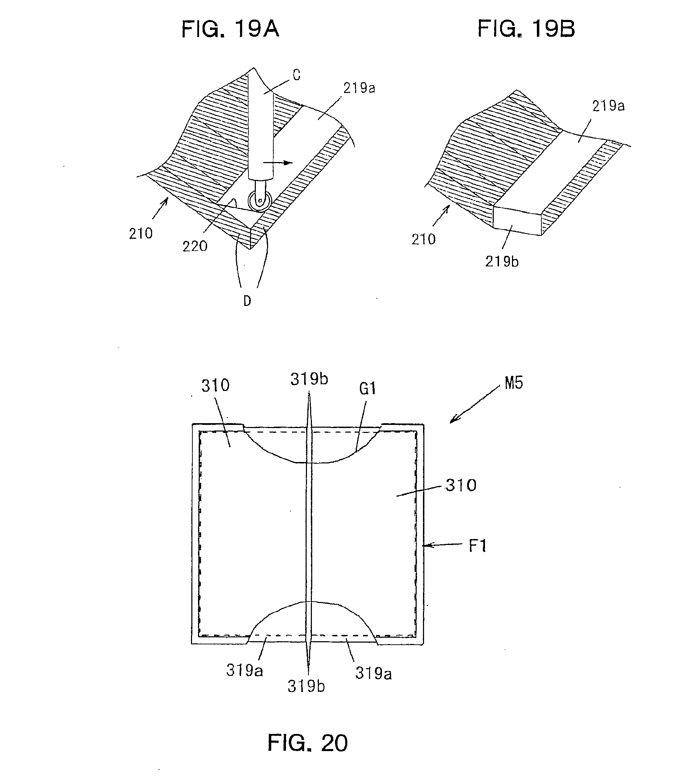

A method of cutting off the corner part of the transparent insulated substrate 211 in the solar battery 210 involves, for example, as shown in Fig. 19A, making a groove-like flaw 220 on a surface near the corner part of the transparent insulated substrate 211 (non-conductive surface region 219a) using a commercially available glass cutter C, and bending the corner part with the flaw 220 being as an origin, thereby forming the non-conductive end face region 219b having the same width as the width W of the non-conductive surface region 219a.

A production process of the thin-film solar battery module M4 according to Embodiment 2-1 is similar to the production process of Embodiment 1-1 except that at the last of the film removing step in the solar battery fabrication step, the non-conductive end face region 219b is formed by cutting off the corner part of the transparent insulated substrate 211, and the connecting method as will be described later is somewhat different.

Also in a case of Embodiment 2-1, as shown in Fig. 18A and Fig. 18B, the neighboring two solar batteries 210 are arranged on the reinforced glass G1 via the adhesion layer 11 in a condition that they are apart from each other. These solar batteries 210 may be connected in parallel, as shown in Fig. 18A, or these solar batteries 210 may be connected in series as shown in Fig. 18B.

When the fabricated solar battery 210 is such that the second electrode layer 214 is arranged on a side of end faces which are opposing to each other of the neighboring two solar batteries 210, parallel connection can be achieved by electrically connecting the second electrode layers 214 which are close to each other of the respective solar batteries 210 by an inter connector 221 via a solder material as shown in Fig. 18A.

Further, by electrically connecting a bus bar 217 on the extraction electrodes 214a which are apart from each other of the respective solar batteries 210 via a solder material, electrically connecting three retrieving lines of the wiring sheet (see Fig. 8 and Fig. 9) to the inter connector 221 and the respective bus bars 217, connecting one retrieving line on the inter connector side to one output line, and connecting two retrieving lines on a bus bar side to other output line, it is possible to retrieve the current generated in the two solar batteries 210 connected in parallel to the outside.

The solar battery 210 may be arranged so that the extraction electrode 214a is disposed on opposing end faces of the neighboring two solar batteries, and the solar batteries 210 may be connected in parallel by connecting the extraction electrodes 214a by an inter connector.

When such parallel connection is employed, it suffices to fabricate only one kind of solar battery 210.

When the neighboring two solar batteries 210 are connected in series, as shown in Fig. 18B, in one solar battery 210, the second electrode layer 214 is disposed on a side of opposing end face, and in the other solar battery 210a, the extraction electrode 214a is disposed on the side of opposing end face, and these second electrode layer 214 and the extraction electrode 214a are connected by the inter connector 221, and the bus bars 217 are connected on surfaces of the extraction electrode 214a and the second electrode layer 214 which are apart from each other. In this case, two kinds of solar batteries 210, 210a are required.

In a case of serial connection, by electrically connecting two retrieving lines of wiring sheet to the bus bars 217 of the respective solar batteries 210 (see Fig. 8 and Fig. 9), and connecting each retrieving line to the respective output line, it is possible to retrieve the current generated in each solar battery 210, 210a to outside.

### (Embodiment 2-2)

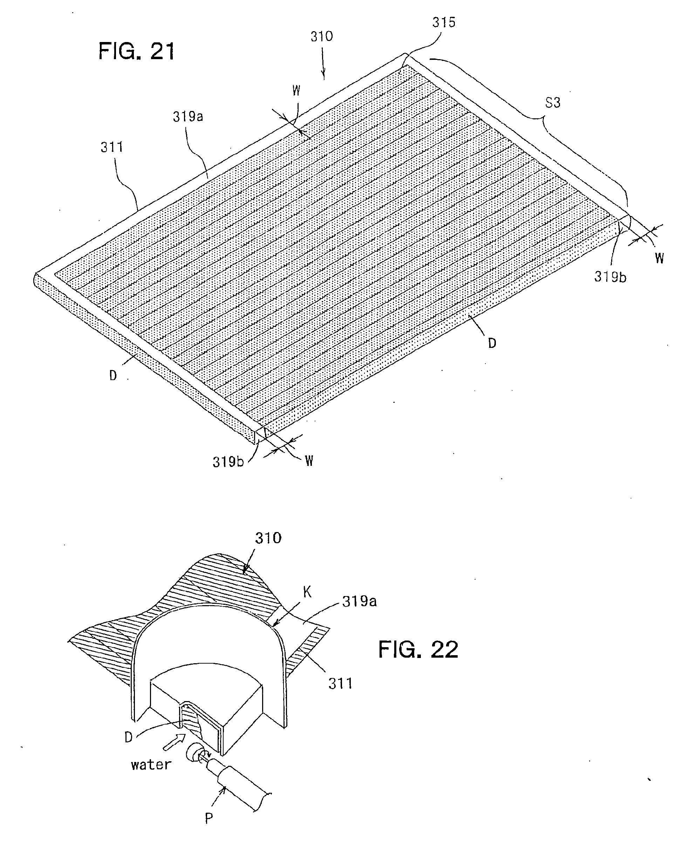

Fig. 20 is a partial section plan view showing a thin-film solar battery module M5 according to Embodiment 2-2, Fig. 21 is a perspective view showing a thin-film solar battery 310 in Embodiment 2-2. In Fig. 20 and Fig. 21, a similar element as that in Embodiment 1-1 is denoted by the same reference numeral.

In the solar battery 210 of Embodiment 2-1 (see Fig. 17), the non-conductive end face region 219b is formed by cutting off the corner part of the transparent insulated substrate 211. The solar battery 310 of Embodiment 2-2 is different from Embodiment 2-1 in that a non-conductive end face region 319b is formed without cutting off a corner part of a transparent insulated substrate 311. Other configuration in Embodiment 2-2 is similar to that of Embodiment 2-1.

In the solar battery 310 of Embodiment 2-2, the non-conductive end face region 319b having the same width as the width W of the non-conductive surface region 319a is formed by polishing or etching an end face of end part positioned at least within the predetermined insulation distance L from the frame F1 which will be attached to the supporting plate (see Fig. 10 and Fig. 20) in opposing end faces of the neighboring two thin-film solar batteries 310. In Fig. 21, the reference numeral 311 denotes an insulated substrate, S3 denotes a string, and 315 denotes a thin-film photoelectric conversion element.

When the non-conductive end face region 319b is formed by polishing, for example, as shown in Fig. 22, after formation of the string S3, exposing an end face part to be polished where the non-conductive end face region of the solar battery 310 is to be formed and covering the peripheral part thereof by setting a covering member K on the solar battery 310, and polishing is carried out by using a handy type polisher P while water is applied on the deposition film D of the end face part to be polished, to remove the deposition film D until the transparent insulated substrate 311 is exposed.

At this time, it is preferred to prevent water and polishing dust from scattering, by means of a collar part provided in the covering member K because it would be necessary to clean a surface of the solar batteries 310 when water and polishing dust scatter to adhere the surface of the solar batteries 310. Further, it is preferred to carry out polishing while sucking water and polishing dust.

When the non-conductive end face region 319b is formed by etching process, deposition film D in an end face part where the non-conductive end face region of the solar battery 310 is to be formed is removed by an etching solution.

The production process of the thin-film solar battery module M5 according to Embodiment 2-2 is similar to the production process of Embodiment 2-1 except that the non-conductive end face region 219b is formed by such a polishing or etching process.

### (Embodiment 2-3)

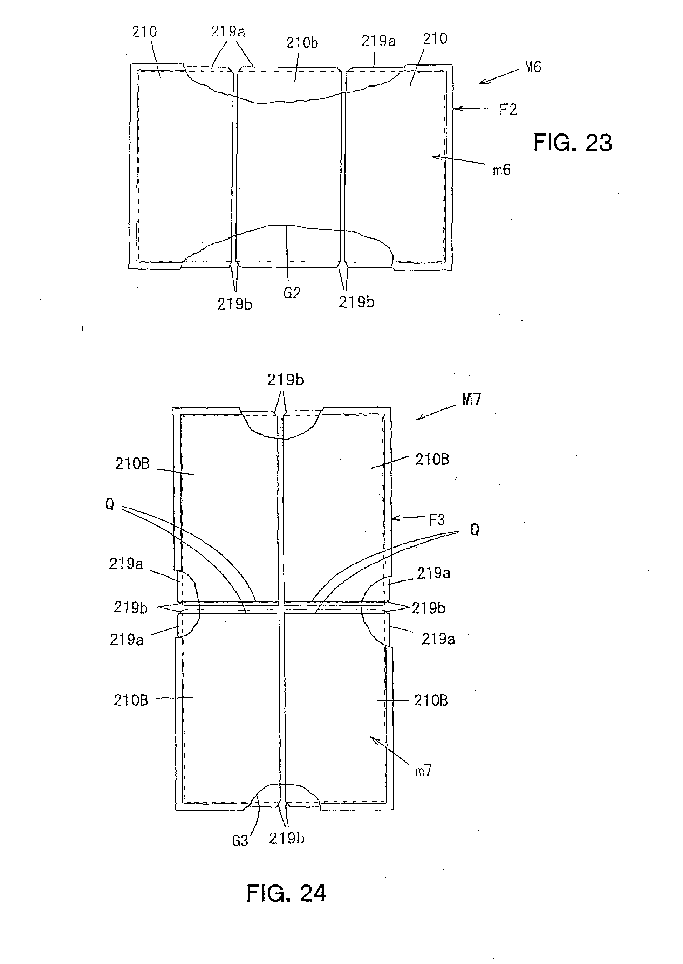

Fig. 23 is a partial sectional plan view showing a thin-film solar battery module according to Embodiment 2-3.

A thin-film solar battery module M6 according to Embodiment 2-3 is formed by fabricating a module body m6 by laterally arranging two solar batteries 210 of Embodiment 2-1 and an one solar battery 210b as will be described later on the rectangular reinforced glass G2, and attaching the reinforced glass G2 and the frame F2 corresponding to a length of each side of an outer circumference of the reinforced glass G2. In Fig. 23, a similar element as that in Embodiment 1-1 is denoted by the same reference numeral.

In this case, as for the solar battery 210b arranged in a center, one of end faces in the serial connecting direction of the string is formed to have the same structure as a right end face of the left cell 210 shown in Fig. 18B, while the other of the end faces is formed to have the same structure as a left end face of the right cell 210a shown in Fig. 18B. That is, in this solar battery 210b, the string is formed up to both end faces which are close to the neighboring solar batteries 210 on both sides. In other words, in this solar battery 210b, two non-conductive surface regions 219a are separately formed on the surface along the side which is close to the frame F2.

Further, in the center solar battery 210b, as shown Fig. 23, the non-conductive end face regions 219b are formed on the both sides of opposing end faces close to the neighboring two solar batteries 210.

In Embodiment 2-3, the two solar batteries 210 on both sides and the center cell 210b are arranged on the reinforced glass G2 via the adhesion layer while they are apart from each other. At this time, it is preferred that the three solar batteries 210, 210b are arranged in an orientation of serial connection by the inter connector as shown in Fig. 18B from the view point of simplification of the wiring structure.

Embodiment 2-3 is similar to Embodiment 2-1 except for the configuration as described above, and may be produced according to the production process of Embodiment 1-1.

### (Embodiment 2-4)

Fig. 24 is a plan view showing a thin-film solar battery module M7 according to Embodiment 2-4.

The thin-film solar battery module M7 according to Embodiment 2-4 has generally similar configuration to the thin-film solar battery module M4 according to Embodiment 2-1 as described above except that four solar batteries 210B are arranged laterally and longitudinally on the rectangular reinforced glass G3 to fabricate a module body m7, and the frame F3 corresponding to a length of each side of an outer circumference of the reinforced glass G3 is attached to the reinforced glass G3 and the module body m7. In Fig. 24, a similar element as that in Embodiment 1-1 is denoted by the same reference numeral.

The thin-film solar battery module M7 according to Embodiment 2-4 may be produced almost according to the production method of Embodiment 2-1, although the reinforced glass G3, frame F3, EVA sheet and the like used herein are larger in size. However, following points are changed.

In a case of Embodiment 2-4, deposition film D adheres on an outer circumferential end face of each solar battery 210B (see Fig. 17), and one long side and one short side of each solar battery 210B neighbor along the frame F3, and remaining long side and short side extend in a direction apart from the frame F3.

Therefore, first, in each solar battery 210B, the non-conductive surface region 219a is formed in a surface outside region along the long side and short side which are close to the frame F3. Secondly, in each solar battery 210B, a corner part in the long side and short side extending in the direction apart from the frame F3, which is close to the frame F3 is cut off, to form the non-conductive end face region 219b. In this manner, it is possible to obtain the dielectric withstand voltage required for the thin-film solar battery module M7.

Thirdly, on a surface of the solar battery 210B, an electric insulation separation groove Q is formed along the short sides close to the neighboring other solar battery 210B in the longitudinal direction of the separation groove. The electric insulation separation groove Q prevents the string from shorting due to the deposition film adhered to outer circumferential end faces of the solar batteries 210B.

The method of producing the electric insulation separation groove Q is similar to the method explained in the modified example of Embodiment 1-1, and involves forming a first groove by removing the photoelectric conversion layer and the second electrode layer by first-stage light beam irradiation, and removing the first electrode layer, the photoelectric conversion layer and the second electrode layer situated on outer side of the first groove, by second-stage light beam irradiation, thereby forming the electric insulation separation groove Q including the first groove.

Also in a case of Embodiment 2-4, the respective solar batteries 210B are arranged apart from each other. In this case, the two solar batteries 210B in laterally arranged rows may be connected in series or in parallel in a manner similar to that in Embodiment 2-1.

### (Embodiment 2-5)

The thin-film solar battery 310 described in Embodiment 2-2 (see Fig. 21) may be used in place of the thin-film solar battery 210 used in Embodiment 2-3 (see Fig. 23). When three solar batteries are arranged, the string of the solar battery arranged in a center may be formed up to just an end in the serial connecting direction as is a case with the Embodiment 2-3, and the non-conductive end face regions of the center solar battery are formed on the both sides of opposing end faces close to the neighboring two solar batteries.

In the thin-film solar battery 210B used in Embodiment 2-4 (Fig. 24), the non-conductive end face region may be formed by polishing or etching as described in Embodiment 2-2 (see Fig. 21 and Fig. 22) rather than forming the non-conductive end face region 219b by cutting off a corner part thereof.

### (Embodiment 3)

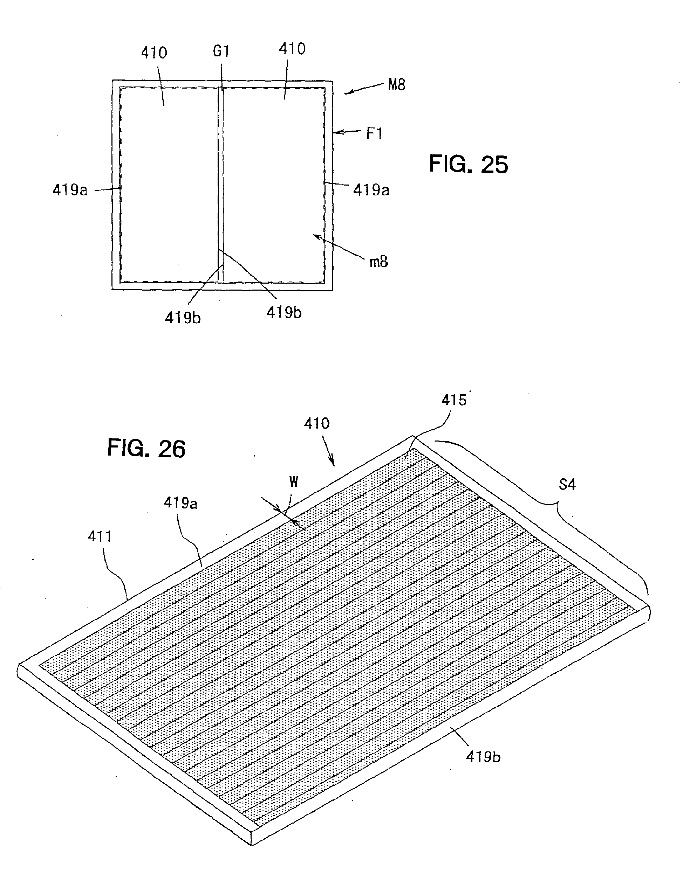

Fig. 25 is a plan view showing a thin-film solar battery module M8 according to Embodiment 3, and Fig. 26 is a perspective view showing a thin-film solar battery 410 in Embodiment 3. In Fig. 25 and Fig. 26, a similar element as that in Embodiment 1-1 is denoted by the same reference numeral. In Fig. 26, 411 denotes an insulated substrate, 415 denotes a thin-film photoelectric conversion element, S4 denotes a string, 419a denotes a non-conductive surface region, 419b denotes a non-conductive end face region, and m8 denotes a module body.

The thin-film solar battery 410 in the thin-film solar battery module M8 is similar to the solar battery 310 in Embodiment 2-2 (see Fig. 21), and is different in that deposition film does not adhere on an outer circumferential end face of the transparent insulated substrate 411.

In the solar battery 410 in Embodiment 3, the first electrode layer, the photoelectric conversion layer and the second electrode layer are formed only on a surface area of the transparent insulated substrate 411 in the string forming step.

Although omitted in illustration, at this time, the transparent insulated substrate 411 is set on a tray dedicated for substrate, and the string S4 is formed while the outer circumferential region having the width W which is close to the frame F of the transparent insulated substrate 411 and an entire outer circumferential end face are covered with a circumferential wall of the tray and a hood portion bent inward from the circumferential wall. As a result, the non-conductive surface region 419a having the width W remains on a surface of the transparent insulated substrate 411, and the non-conductive end face region 419b remains on the entire outer circumferential end face.

According to this method, it is possible to omit the step of forming the non-conductive surface region by removing the first electrode layer, the photoelectric conversion layer and the second electrode layer by light beam and the step of forming the non-conductive end face region by polishing or etching, that are conducted in Embodiment 2-2.

### (Other Embodiments)

1. The protective member explained in Embodiment 1-4 may be disposed between the neighboring solar batteries in Embodiment 2-1 to Embodiment 3 to protect end faces of the substrates.
2. In the solar battery 410 in Embodiment 3, the string S4 is formed only on the surface of the transparent insulated substrate 411 so that no deposition film is formed on the outer circumferential end face, and the string S4 is formed up to a boundary with an end face opposing to the neighboring solar battery, however a non-conductive surface region which is thinner than the width W may be formed on an insulated substrate surface in the vicinity of the boundary. This is because, if there is even a small gap between the end face of the transparent insulated substrate 411 and the circumferential wall of the tray in setting the transparent insulated substrate 411 on the tray dedicated for substrate, the deposition film adheres in the vicinity of the boundary over an entire length of the end face, so that a predetermined dielectric withstand voltage is no longer ensured. Such problem is more significant when the end face of the transparent insulated substrate 411 is machined roundly. Therefore, by forming the string on the surface of the transparent insulated substrate 411 using the tray in which a hood portion is formed along an entire circumferential wall, it is possible to securely prevent the deposition film from adhering to the end face, and to ensure the predetermined dielectric withstand voltage.
3. In the above Embodiment 1-1 to Embodiment 3, a case where the neighboring solar batteries are arranged apart from each other is exemplified, however, the neighboring solar batteries can be arranged in contact with each other with the same solar battery configuration, for example, by using a polyimide substrate which is resistant to substrate cracking.
4. In the above Embodiment 1-1 to Embodiment 3, a case where the frame is a metal frame is exemplified, however, an insulating frame may be used. In such a case, the film removing step in the solar battery fabrication step is omitted. Further, as the thin-film solar battery that is fabricated in the solar battery fabrication step in which the film removing step is omitted, a commercially available product may be used, and in such a case, an entire solar battery fabrication step may be omitted.

## Claims

1. A thin-film solar battery module comprising:
a plurality of thin-film solar batteries;
a supporting plate; and
a frame,
the thin-film solar battery having a string in which a plurality of thin-film photoelectric conversion elements, each formed by sequentially stacking a first electrode layer, a photoelectric conversion layer and a second electrode layer on a surface of an insulated substrate, are electrically connected in series,
wherein the frame is attached to an outer circumference of the supporting plate in a condition that the plurality of thin-film solar batteries are arranged and fixed on the supporting plate.

2. The thin-film solar battery module according to claim 1,
wherein the supporting plate is a reinforced glass.

3. The thin-film solar battery module according to claim 1,
wherein the frame is made of a conductive material.

4. The thin-film solar battery module according to claim 1,
wherein in the plurality of thin-film solar batteries, neighboring two thin-film solar batteries are arranged apart from each other.

5. The thin-film solar battery module according to claim 4, further comprising a protective member between the neighboring two thin-film solar batteries, that protects opposing end edges of the respective thin-film solar batteries.

6. The thin-film solar battery module according to claim 1,
wherein in a case where the frame is made of a conductive material, in the thin-film solar battery, a surface of the insulated substrate within a predetermined insulation distance from the frame is a non-conductive surface region, and the string is situated on the in side of an end face which is close to the frame in the insulated substrate, and a part situated within the predetermined insulation distance in an end face opposing to the other of the neighboring thin-film solar batteries is a non-conductive end face region.

7. The thin-film solar battery module according to claim 6,
wherein the non-conductive end face region is formed by cutting off a corner part of the insulated substrate or by polishing or etching an end face of the insulated substrate.

8. The thin-film solar battery module according to claim 1,
wherein in a case where the frame is made of a conductive material, in the thin-film solar battery, a surface of the insulated substrate within a predetermined insulation distance from the frame is a first non-conductive surface region, and a surface of the insulated substrate which is close to the other of the neighboring thin-film solar batteries is a second non-conductive surface region, and the string is situated on the inside of an end face of the insulated substrate, the second non-conductive surface region has the same width as that of the first non-conductive surface region.

9. The thin-film solar battery module according to claim 6 or 8,
wherein in the thin-film solar battery, the second electrode layer on one end in a serial connecting direction of the string is an extraction electrode for the first electrode layer of the neighboring thin-film photoelectric conversion element, the photoelectric conversion layer has a first conductive type semiconductor layer on the first electrode layer side and a second conductive type semiconductor layer on the second electrode layer side, and in the two neighboring thin-film solar batteries arranged in the serial connecting direction of the string, strings of the two thin-film solar batteries are connected in series by being electrically connected in such orientation that the second electrode layer of one of the thin-film solar batteries and the extraction electrode of the other of the thin-film solar batteries are close to each other, and electrically connecting between the second electrode layer and the extraction electrode.

10. The thin-film solar battery module according to claim 6 or 8,
wherein
in the thin-film solar battery, the second electrode layer at one end in the serial connecting direction of the string is an extraction electrode for the first electrode layer of the neighboring thin-film photoelectric conversion element, and the photoelectric conversion layer has a first conductive type semiconductor layer on a side of the first electrode layer and a second conductive type semiconductor layer on a side of the second electrode layer, and in the two neighboring thin-film solar batteries arranged in the serial connecting direction of the string, strings of the two thin-film solar batteries are connected in parallel by arranging the thin-film solar batteries in such an orientation that the respective extraction electrodes are apart from each other or in such an orientation that the extraction electrodes are close to each other, and electrically connecting between the neighboring second electrode layers or between the neighboring extraction electrodes of the respective thin-film solar batteries.

11. A method of producing a thin-film solar battery module comprising:
a sealing and fixing step that arranges a plurality of thin-film solar batteries on a supporting plate and sealing and fixing them by an insulating sealing material, each of the thin-film solar batteries having a string made up of a plurality of thin-film photoelectric conversion elements electrically connected in series, the thin-film photoelectric conversion element being formed by sequentially stacking a first electrode layer, a photoelectric conversion layer and a second electrode layer on an insulating substrate; and
a frame attaching step that attaches a frame to an outer circumference of the supporting plate that supports the plurality of thin-film solar batteries.

12. The production method of a thin-film solar battery module according to claim 11, wherein in the sealing and fixing step, the plurality of thin-film solar batteries are arranged so that the neighboring two thin-film solar batteries are arranged apart from each other.

13. The production method of a thin-film solar battery module according to claim 11, wherein the sealing and fixing step further includes the step of disposing a protective member on the supporting plate, and arranging two thin-film solar batteries on the supporting plate so that they sandwich the protective member.

14. The production method of a thin-film solar battery module according to claim 11, further comprising a solar battery fabrication step that fabricates the plurality of thin-film solar batteries, prior to the sealing and fixing step, the solar battery fabrication step including, when the frame is made of a conductive material,
a string forming step that forms a string only on an one surface of the insulated substrate, and
a film removing step that removes the string in a predetermined surface part on the insulated substrate,
wherein in the film removing step, non-conductive surface region is formed by removing the string in the predetermined surface part on the insulated substrate situated within a predetermined insulation distance from the frame which will be attached to the supporting plate in the subsequent frame attaching step is removed.

15. The production method of a thin-film solar battery module according to claim 11, further comprising a solar battery fabrication step that fabricates the plurality of thin-film solar batteries, prior to the sealing and fixing step, the solar battery fabrication step including:
a string forming step that forms the string at least on a surface of the insulated substrate, and
a film removing step that removes the string in a predetermined surface part on the insulated substrate, when the frame is made of a conductive material,
wherein in the film removing step, a non-conductive surface region is formed by removing the string in the predetermined surface part on the insulated substrate situated within a predetermined insulation distance from the frame which will be attached to the supporting plate in the subsequent frame attaching step, and further when at least one electrode layer of the first electrode layer and the second electrode layer adheres to an outer circumferential end face of the insulated substrate in the string forming step, a non-conductive end face region is formed by removing the electrode layer adhering in a part situated at least within the predetermined insulation distance in an end face which will be close to the neighboring thin-film solar battery when the plurality of thin-film solar batteries are arranged in the subsequent sealing and fixing step.

16. The production method of a thin-film solar battery module according to claim 15, wherein in the film removing step, the non-conductive end face region is formed by cutting off a corner part of a side of the end face having the electrode layer of the insulated substrate, or polishing or etching an end face having the electrode layer of the insulated substrate.

17. The production method of a thin-film solar battery module according to claim 11, further comprising a solar battery fabrication step that fabricates the plurality of thin-film solar batteries, prior to the sealing and fixing step, the solar battery fabrication step including:
a string forming step that forms the string at least on a surface of the insulated substrate, and
a film removing step that removes the string in a predetermined surface part on the insulated substrate, when the frame is made of a conductive material,
wherein in the film removing step, a first non-conductive surface region is formed by removing the string on in the predetermined surface part of the insulated substrate situated within a predetermined insulation distance from the frame which will be attached to the subsequent frame attaching step, and further when at least one electrode layer of the first electrode layer and the second electrode layer adheres to an outer circumferential end face of the insulated substrate in the string forming step, a second non-conductive surface region having the same width as the first non-conductive surface region is formed by removing the string in the predetermined surface part which will be close to the neighboring thin-film solar battery when the plurality of thin-film solar batteries are arranged in the subsequent sealing and fixing step.

18. The production method of a thin-film solar battery module according to any one of claims 14, 15 and 17, wherein in the film removing step, the non-conductive surface region is formed by removing the first electrode layer, the photoelectric conversion layer and the second electrode layer in an outer circumferential region on a surface of the insulated substrate by light beam.
